# EUROPEAN PATENT APPLICATION

(11) **EP 4 642 177 A1**
(43) Date of publication of application: **29.10.2025**
(21) Application number: 24219104.7
(22) Date of filing: 11.12.2024
(51) Int. Cl.: H05K 7/20, H01L 23/473

(54) **ELECTRONIC ASSEMBLY WITH A GASKET FOR VENTING COOLANT TO AN OVERFLOW VESSEL**

(30) Priority: 26.04.2024 US 202463639081 P; 18.06.2024 US 202418746700
(71) Applicant: Deere & Company, Moline, IL 61265 (US)
(72) Inventor: BRANDT, Patrick, Fargo, 58102 (US); LIPP, Daniel, Fargo, 58102 (US); LOKEN, David, Fargo, 58102 (US); KING, Kevin, Waterloo, 50613 (US)
(74) Representative: Reddie & Grose LLP

(57) **Abstract**

A gasket (20) is configured to isolate or hermetically seal an electronics cavity (12) from the coolant circulating in the coolant cavity or coolant channel, wherein the gasket comprises seal with two outer lips (16, 116) and a primary channel (17) between the outer lips for conveying coolant to an exit aperture within the primary channel if coolant penetrates a penetrated one of the outer lips facing the coolant cavity to prevent the ingress of fluid into the electronics cavity. A primary overflow vessel (464, 513) is capable of receiving coolant from the exit aperture via an overflow linkage channel. A first sensor (464) is configured to detect the presence of coolant in the primary overflow vessel and to generate a sensor data or a sensor signal indicative of the presence or level of coolant in the primary overflow vessel.

## Description

### Field

This disclosure relates to an electronic assembly with a gasket for venting coolant to an overflow vessel.

### Background

In some prior art, an electronic device or electronic assembly can be cooled with fluid or coolant, where the coolant is pressurized or pumped to ensure flow through the device or electronic assembly to remove heat, which provides cooling. In certain prior art, there can be multiple cavities with fluids or air that need to remain separate, where a gasket can create a seal between a coolant cavity and an electronics cavity. If the gasket deteriorates or does not perform adequately, there is a risk of the fluid leaking from the coolant cavity, through the seal formed by the gasket, where the electronic device may be damaged or fail from the ingress of the fluid or coolant into the electronics cavity. Thus, there is a need for an improved electronic assembly with a gasket for venting moisture, such as routing the moisture away from the electronics cavity.

### Summary

In accordance with one embodiment, an electronic assembly comprises a first housing portion having an electronics cavity for housing a circuit board, where one or more heat-generating electronic components are mounted on a respective thermal plate or on the respective circuit board. A second housing portion or thermal plate has a coolant cavity or coolant channel for circulating a coolant to dissipate heat from the heat-generating electronic component. A gasket is configured to isolate or hermetically seal the electronics cavity from the coolant circulating in the coolant cavity or coolant channel, wherein the gasket comprises seal with two outer lips and a primary channel between the outer lips for conveying coolant to an exit aperture within the primary channel if coolant breaches or penetrates (e.g., leaks or seeps past) an outer lip facing the coolant cavity to prevent the ingress of fluid into the electronics cavity. A primary overflow vessel is capable of receiving coolant from the exit aperture via an overflow linkage channel. A first sensor is configured to detect the presence of coolant in the primary overflow vessel and to generate a sensor data or a sensor signal indicative of the presence or level of coolant in the primary overflow vessel. An electronic display or alert device configured to display a visual alert or audible alert if the first sensor detects the presence of coolant in a primary overflow vessel based on the sensor data or sensor signal.

### Brief Description of Drawings

FIG. 1 is a cross-section of one embodiment of an electronics assembly that is connected to a heat exchanger (e.g., radiator) and a pump for circulating a coolant within a coolant cavity of the electronic assembly.
FIG. 2A shows a plan view of one embodiment of the electronic assembly with a second housing portion removed to show an interior or top of the first housing portion.
FIG. 2B shows an enlarged portion of FIG. 2A in the rectangular region 2B of FIG. 2A.
FIG. 3 shows an enlarged portion of FIG. 2B in the rectangular region 3 of FIG. 2B.
FIG. 4 shows an enlarged portion of FIG. 2B in the rectangular region 3 of FIG. 2B with arrows indicating one possible flow path of coolant.
FIG. 5 shows a cross-section of an electronics assembly comprising a first housing portion and a second housing portion in the region of a venting or drain channel (e.g., vertical channel).
FIG. 6 shows a plan view of the electronic assembly with a second housing portion removed to show an interior or top of the first housing portion as viewed along reference line 6-6 of FIG. 5.
FIG. 7 shows an enlarged cross-section of an electronics assembly of FIG. 5 comprising a first housing portion and a second housing portion in the region of a venting or drain channel (e.g., vertical channel).
FIG. 8 shows a plan view of the electronic assembly with a second housing portion removed to show an interior or top of the first housing portion.
FIG. 9 shows a plan view of one embodiment of a gasket, where the gasket is illustrated as separate from or removed from the electronic assembly.
FIG. 10 shows an enlarged rectangular region (10) of the plan view of FIG. 9 of the gasket.
FIG. 11 shows an enlarged rectangular region (11) of the plan view of FIG. 9 of the gasket.
FIG. 12 shows a cross-section of the gasket of FIG. 11 installed (or dispensed) in the electronic assembly, where the electronic assembly of FIG. 12 is cut-away to reveal a cross-section of the gasket in alignment with FIG. 11.
FIG. 13 shows a cross-sectional portion of the gasket of FIG. 10 in the region 13, where the gasket is installed (or dispensed) in the electronic assembly, where the electronic assembly is cut-away to reveal a perspective view of a vertical channel or drain within the gasket.
FIG. 14 shows one embodiment of a perspective end view of the electronic assembly, where electrical openings and recesses are revealed.
FIG. 15 shows one embodiment of a perspective end view of the electronic assembly, where one or more recesses can communicate with an exit aperture for coolant overflow or leakage.
FIG. 16 shows one embodiment of a cross-sectional perspective view of the electronic assembly, where the electronic assembly is connected to and housed within or outside a transmission housing or gearbox housing.
FIG. 17 shows one embodiment of a cross-sectional, perspective view of the housing of the electronic assembly with the circuit board, electronic components, and other components removed to reveal the interior of the housing of the electronics assembly, where the electronic assembly is connected to and housed within or outside a transmission housing or gearbox housing and where a recess in the end of the electronics assembly and a portion of the transmission housing collectively form a primary overflow vessel.
FIG. 18 shows one embodiment of a cross-sectional, perspective view of the housing of the electronic assembly with the circuit board, electronic components, and other components removed to reveal the interior of the housing of the electronics assembly, where the electronic assembly is connected to and housed within or outside a transmission housing or gearbox housing and where a recess in the end of the electronics assembly and a portion of the transmission housing collectively form a primary overflow vessel.
FIG. 19 is a block diagram of an alert system for alerting an operator or user of a vehicle with respect to a possible leak of the gasket of the electronic assembly.
FIG. 20 is a perspective view of one embodiment of an end cap or terminating cap with visual inspection window.
FIG. 21 is a cross-sectional view of one embodiment of a fluid level gauge with a cylindrical viewing member and two fluidic connection ports.
FIG. 22 is a cross-sectional view of one embodiment of a transmission system that comprises a gearbox, an electric machine, and an electronic assembly with a gasket for venting or directing fluid to an overflow vessel.
FIG. 23 is an enlarged lower region of the transmission system of FIG. 22.
FIG. 24 is a cross-section perspective view of an alternate embodiment of a housing portion of the electronic assembly with a generally U-shaped gasket or rectangular gasket with a central channel for directing overflow or leaking fluid (e.g., coolant) to an overflow vessel.
FIG. 25 shows an enlarged region of the housing portion of the electronic assembly of FIG. 24.
FIG. 26 shows an enlarged cross-section the housing portions of an electronic assembly with an illustrative gasket, consistent with FIG. 24.
FIG. 27 is a cross-sectional view of another embodiment of a transmission system that comprises a gearbox, an electric machine, and an electronic assembly with a gasket for venting or directing fluid to an overflow vessel.

Like reference numbers in any set of two or more drawings indicate similar or like features, elements, steps or methods.

### Detailed Description

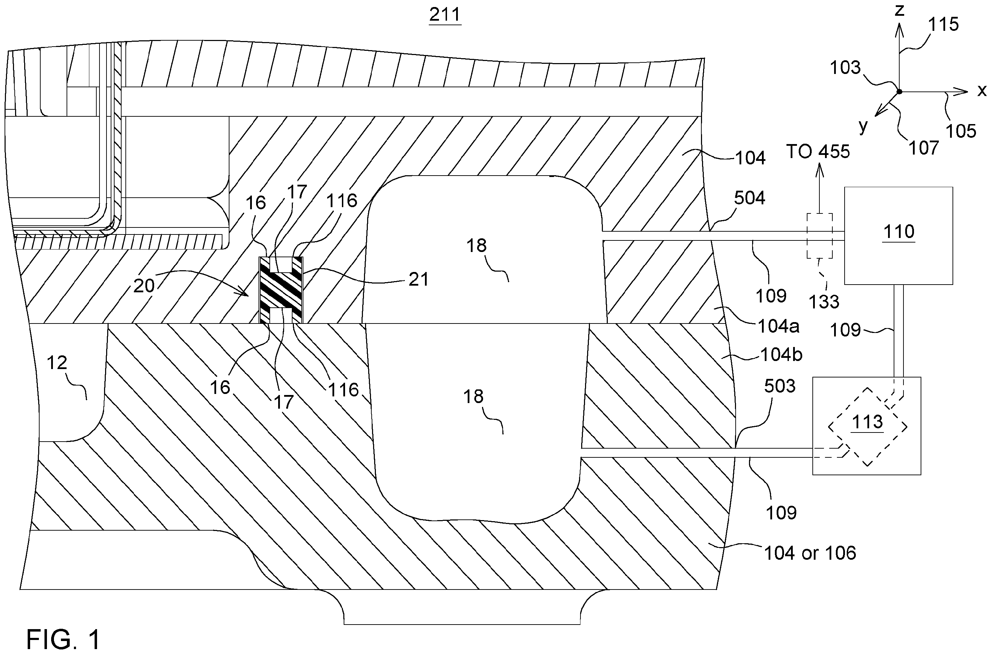

FIG. 1 is a cross-section of electronics assembly 211 that is connected to a heat exchanger 113 (e.g., radiator) and a pump 110 for circulating a coolant (or fluid) within a coolant cavity region 18 of the electronic assembly 211 to dissipate heat from the electronic assembly 211. As illustrated, the heat exchanger 113 and pump 110 are hydraulically connected in series with tubing 109 to circulate coolant (e.g., within a target pressure range and a corresponding flow rate, which is expressed in volume per unit time) within the electronics assembly 211 or the coolant cavity region 18. In one embodiment, the pump 110 is configured to circulate coolant within the electronic assembly 211 to promote adequate dissipation of thermal energy from one or more heat generating electronic components (46, 146), while the target pressure range and/or corresponding flow rate of the coolant is consistent with maintaining a reliable seal of the gasket (20,120) (e.g., with respect to an electronics cavity region 12 that is filled with air at about ambient, external environmental air pressure and/or avoiding or reducing the potential introduction of air or air bubbles into the circulated coolant). Additional tubing 109 connects the heat exchanger 113 and pump 110 to ports (e.g., with suitable connectors, such as compression fittings or threaded fittings) in the housing (102, 106) of the electronic assembly.

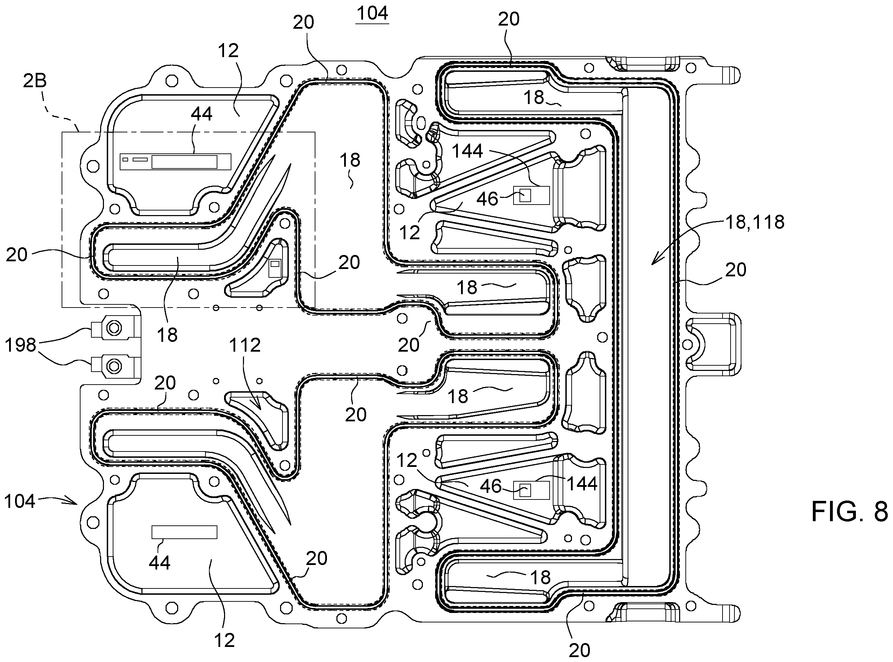

As illustrated in FIG. 1, the Cartesian coordinate system 103 illustrates the X-axis 105, Y-axis 107 and Z-axis 115, which are substantially perpendicular. The electronics assembly 211 may have electrical terminals 198 (in FIG. 8), such as direct-current (DC) terminals to apply direct current (or alternating current (AC) terminals to apply AC current) to energize one or more circuit boards (44, 144) and the heat- generating electronic components (46,146) associated with the circuit boards. If the electronics assembly 211 provides an inverter, DC-DC converter, power electronics, controller, or sensor, additional output terminals, input terminals or data terminals may be available or accessible to access via connectors on the exterior of the housing (102, 106).

In accordance with one embodiment in FIG. 1, an electronic assembly 211 comprises a first housing portion 106 (or a second housing portion 102, or both) having an electronics cavity region 12 for housing a circuit board 44 with one or more heat-generating electronic components 46 mounted on a respective thermal plate (104, 502; e.g., heat sink or cold plate assembly) and/or on a respective circuit board 44. In some configurations the thermal plate (104, 502) may comprise multiple segments or thermal plate components (104a, 104b) that are mechanically coupled together to support, form or define one or more coolant cavities (18, 118) or channels for circulating coolant within the electronics assembly (211, 311) to dissipate thermal energy. Further in some embodiments, an electronics cavity region (12,112) may house circuit boards (44, 144) and heat generating electronic components (46, 146) (e.g., electronic components or electrical components mounted on or in the circuit boards (44, 144)). A second housing portion 102 or thermal plate (502, 104a, 104b) has a coolant cavity region 18 or coolant channel for circulating a coolant to dissipate heat from one or more heat-generating electronic components 46. In certain configurations, the first housing portion 106 comprises a base housing portion or lower housing portion and the second housing portion comprises

In one embodiment, a gasket 20 is disposed or compressed to seal at an interface between the first housing portion 106 and a second housing portion 102, where the interface may comprise a gasket recess 21, such as a groove, or a channel to receive a portion of the gasket 20. The gasket recess 21 may be located in the first housing portion 106, the second housing portion 102, or both. If the gasket recess 21 is located in both first housing portion 106 and the second housing portion 102, the gasket recess may comprise a first gasket recess in the first housing portion 106 and a second gasket recess in the second housing portion 102, where the first gasket recess and the second gasket recess (e.g., slot or groove in a flange) are aligned or registered spatially in multiple dimensions (e.g., along the X-axis 105, the Y-axis 107, and the Z-axis 115) to receive and retain (e.g., mechanically or by a press fit or interference fit) the gasket 20 if or when the first housing portion 106 and the second housing portion 102 are connected or joined by fasteners. Each of the fasteners may comprise a bolt that engage a cylindrical bore in one housing portion (102, 106) and a threaded bore in an adjoining housing portion (102, 106), for example.

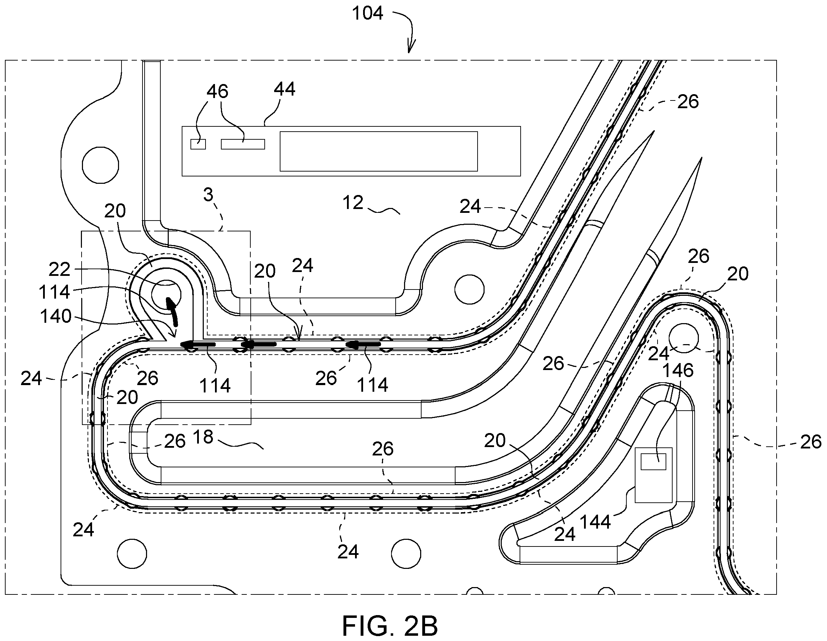

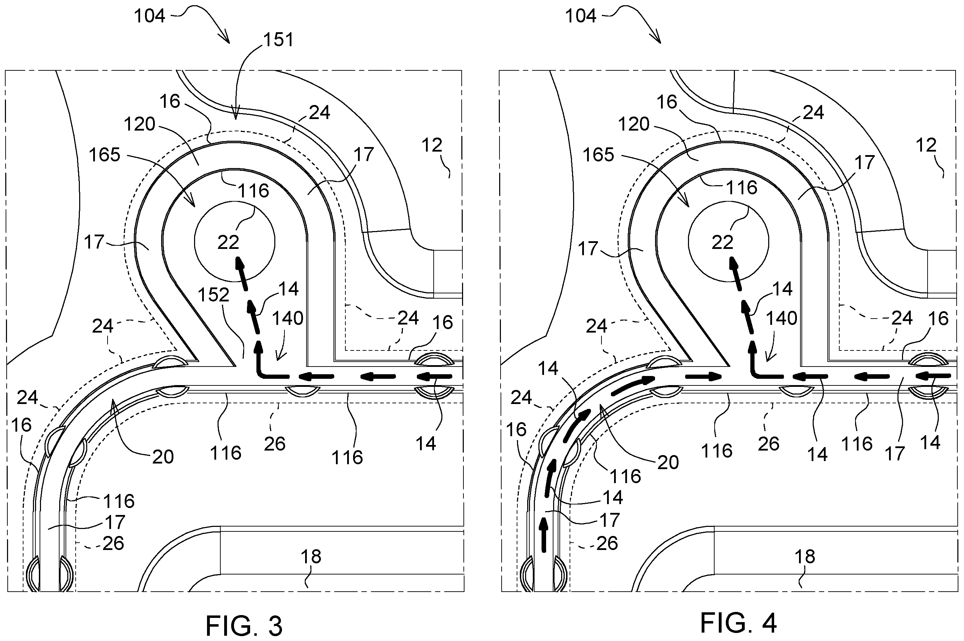

In FIG. 1, a gasket 20 is configured to isolate or hermetically seal the electronics cavity region 12 from the coolant circulating in the coolant cavity region 18 or coolant channel, wherein the gasket 20 comprises a seal with two outer lips (16, 116) and a primary channel 17 between the outer lips (16, 116) for conveying coolant to an exit aperture (e.g., 140 in FIG. 2B and FIG. 3) within the primary channel 17 if coolant breaches or penetrates one of the outer lips (16, 116) facing the coolant cavity to prevent the ingress of fluid into the electronics cavity region 12. As used throughout this document, a lip (16, 116, 216, 316) of any gasket (20, 120) shall be synonymous with a wall of any gasket; accordingly an outer lip (16, 116, 216, 316) shall be synonymous with an outer wall of any gasket (20, 120). The lips or walls are spaced apart from each other by a gap that defines a primary channel (17,117) as a substantially longitudinal channel, such as a groove or channel that can direct, carry or transport fluid, lubricant or coolant. If an outer lip (16, 116) or gasket (20, 120) is breached or penetrated by a fluid or coolant, the outer lip may be referred to as a breached lip, penetrated lip, breached seal, or penetrated seal, for example.

The gasket 20 may be composed of a compressible material, such as an elastomer, (synthetic) rubber, plastic or a polymer, or a composite material that comprises an elastomeric, polymeric or plastic matrix that binds or embeds a filler, such as fiberglass, ceramic reinforcing structures, metallic reinforcing structures, carbon fiber, or the like. The gasket 20 may comprise a preformed compressible flexible gasket with one or more apertures (40,140) in communication with a primary channel 17 to direct or redirect coolant or fluid upon leakage of (at least) one of the two outer lips (16, 116).

In FIG. 2B, FIG. 3 and FIG. 4, the exit aperture 140 in the wall or lip (16, 116) of the gasket (20,120, 220) forms a passageway between the channel 17 and the relief region 165; the exit aperture 140 may be shown in dashed lines. The exit aperture (40,140) may be connected to gravity feed coolant, liquid, or lubricant, via one or more passageways, channels, conduits, pipes, tubing or otherwise, to a reservoir (not shown) or container for storage or prospective disposal.

In the electronics assembly 211, the exit aperture (40, 140), alone, or together with the venting path, may be configured in accordance with various examples that are cumulative or separately implemented. During a normal state of operation when the gasket (20, 120) is fully functional the auxiliary coolant flow path 14 within and along the channel (17, 117) is inactive and dry. However, during any (partially) breached state of operation of one lip (16, 116, 216, 316) of the gasket (20, 120), the auxiliary coolant flow path 14 or weep path can be active to convey or direct flow of the (leaking) coolant within and along the channel (17, 117) if one or more lips or walls (16, 116, 216,316) of the gasket (20, 120) are hydraulically breached by fluid or coolant.

Under a first example to support a breached state of operation of one lip (16, 116, 216, 316) of the gasket (20, 120), the electronics assembly 211 comprises an exit aperture 140 that is disposed in one side-wall (e.g., of a lip 16 of the gasket 20 or a non-penetrated, non-leaking, or non-breached one of the lips 16) of the gasket, 20, 120, (e.g., which faces the electronics cavity region 12 ) and wherein the exit aperture 140 vents the primary channel 17; for example, the exit aperture 140 is in hydraulic communication with a relief region 165, which is bounded by a secondary gasket 120 (of FIG. 2B, FIG. 3 and FIG. 4) or another secondary seal to contain the coolant from reaching the electronics cavity region 12. For example, the secondary gasket 120 or secondary seal may have an outer perimeter 151 (in FIG. 3) that surrounds at least partially in inner perimeter 152 of the primary gasket 20 in the region of the exit aperture 140. Further, within or inward from the outer perimeter 151, there may be a vent opening 22 (e.g., vertical hole, vertical drain hole, or vertical channel) in the first housing portion 106 or second housing portion 102: (a) to vent or drain the coolant outside of the electronic assembly 211, or (b) to vent or to drain the coolant to a coolant retention cavity or container (e.g., removable container that is removably attached to the electronic assembly 211).

Under a second example to support a breached state of operation of one lip (16, 116, 216, 316) of the gasket (20, 120), a reservoir or removable container (not shown) comprises a container for holding (e.g., temporarily holding until removed and emptied by a service technician) the vented coolant or received overflow coolant, where the removable container has container threads that engage corresponding housing threads of the first housing portion 106 or the second housing portion 102. For example, a substantially cylindrical container comprises internal female threads along a central axis of the container, an annular gasket or annular seal that coaxially and outwardly located from the central axis to seal a generally planar end of the container to the housing of the electronic assembly 211, and one or more intermediate holes in the generally planar end of the substantially cylindrical container between the central axis and the annular seal to allow the coolant, fluid, or lubricant to drip or flow into the container.

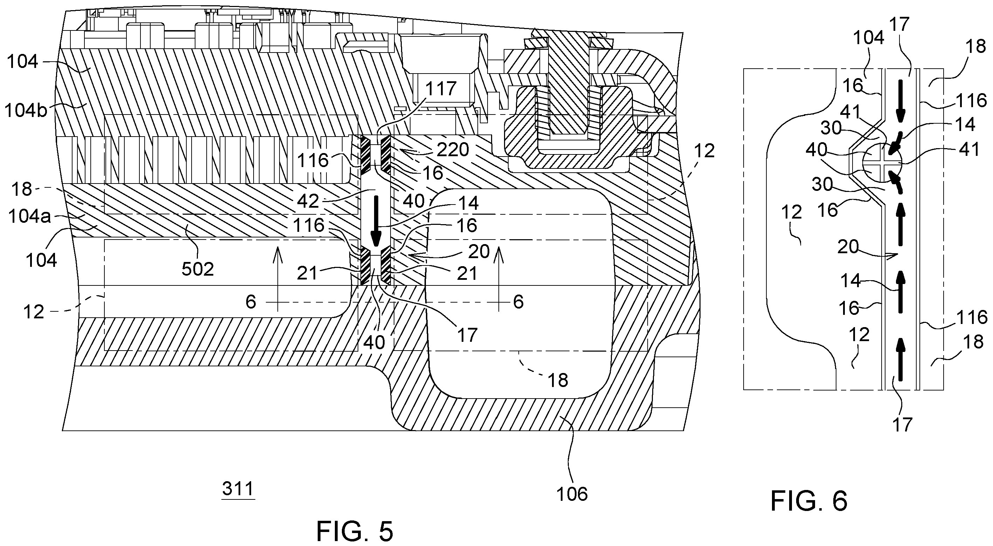

Under a third example to support a breached state of operation of one lip (16, 116, 216, 316) of the gasket (20, 120) in accordance with an alternate embodiment of an electronic assembly 311 (of FIG. 5 and FIG. 6) in the first housing portion 106 or the second housing portion 102 there is a secondary channel 42, such as a drain channel or vertical channel, that: (a) may be generally perpendicular to the primary channel 17 and (b) if a lip of the gasket is breached, the secondary channel 42 serially receives coolant from the primary channel 17 to route the received coolant away from one or more electronics cavity regions 12 or to route the coolant outside of the electronics assembly 311 (e.g., to the ground for suitable water coolant in compliance with applicable laws and regulations), or to a coolant overflow container (e.g., removable container).

Under a fourth example (of FIG. 5 and FIG. 6) to support a breached state of operation of one lip (16, 116, 216, 316) of the gasket (20, 120), the exit aperture 40 is disposed within a central portion or bottom wall of the primary channel 17 of the gasket 20. For example, the exit aperture 40 is disposed within a central portion or bottom wall 30 between the lips 16 of the gasket 20. Further, one or more lips 16 of the gasket 12 may isolate coolant from an electronics cavity region 12 that is bounded by an adjoining lip 16 or coolant cavity adjoining lip 16 of the gasket 20.

Under a fifth example to support a (partially) breached state of operation of one lip (16, 116, 216, 316) of the gasket (20, 120), the exit aperture is disposed: (a) as exit aperture 140 within a sidewall of the gasket 20; (b) as exit aperture 40 within a central portion, or bottom wall 30 of the primary channel 17 of the gasket 20, or both. Further, in some embodiments, the exit aperture 40 is configured to have a reinforcing member 41, strip, cross or grid that radially traverses the aperture (e.g., to add structural support to the gasket 20).

In one embodiment, the gasket 20 has outer lips (16, 116) that are connected via a perpendicular bottom wall 30, where the bottom wall 30 and outer lips (16, 116) define a primary channel 17 for venting fluid along an auxiliary coolant flow path (14, 114) (e.g., primary coolant flow path) of the gasket 20 or a gasket recess in the housing (102, 106) that retains, contains, supports, or receives the gasket 20 on a planar flange or within a gasket recess in a substantially planar flange. In certain configurations, the bottom wall 30 comprises a transverse portion of gasket 20 that joins the outer lips (16, 116).

A first outer lip or outer lip (16, 116) of the gasket 20 may define a boundary of the electronics cavity region 12; such first outer lip that faces or bounds the electronics cavity region (12, 112) can be referred to as an electronics-cavity-adjoining lip. A second outer lip (16, 116) or outer lip (16, 116) of the gasket 20 may define a boundary of the coolant cavity region 18; such second outer lip that faces or bounds the coolant cavity region 18 can be referred to as a coolant-cavity-adjoining lip. The first outer lip or the second outer lip (16, 116) may also face or bound a lubricant cavity region, such as an interior volume of the transmission or gearbox or the transmission pan, to isolate the lubricant (e.g., oil or hydraulic fluid) from an electronics cavity region (12, 112), a coolant cavity region (18, 118), or both.

In certain configurations, the gasket 20 has a generally H-shaped cross-section, although an h-shaped cross-section (e.g., a modified H-shape with one segment of the H deleted), U-shaped cross section, a polygonal cross-section with one or more recessed channels (17, 117, 217) or generally rectangular cross-section with one or more recessed channels (17,117, 217) can be used, for example. In some embodiments, the gasket 20 is commercially available and can be structured as a unitary or monolithic seal that creates two distinct sealed volumes or regions (e.g., sealed electronics cavity region 12 region and a sealed coolant cavity region 18) in close proximity. Here, the gasket 20 is improved by using the primary channel 17, such as a recess, groove, slot, air gap, or mini-aqueduct-like space between the two lips (16, 116) of the gasket 20, to transport any leaking liquid (if present) or coolant (if present). If any leaking fluid or leaking coolant is present in the channel (17, 117, 217) (e.g., migrating, seeping or osmotically present from sealed the coolant cavity region 18), the channel (17, 117, 217) directs the leaking coolant or fluid along an auxiliary coolant flow path (14, 114) defined by the channel (17, 117, 217) of the gasket 20 or gasket recess 21 in the housing (102, 106) to a relief region (e.g., 165) of lower pressure than the coolant within the coolant cavity region 18; greatly reducing the risk of fluid or coolant getting into the electronics cavity region 12.

In accordance with one embodiment, the gasket 20 requires a minimum of two seal edges, two walls, or two lips (16, 116) and a primary channel (17, 117, 217) that defines hollow space, gap, recess, groove, or auxiliary coolant flow path 14 between the seal edges, walls or lips 16. Further, the primary channel (17, 117, 217) is of sufficient cross-section to direct or divert the coolant to or through the exit aperture (40, 140) to prevent coolant from entering into the electronic cavity region 12 (e.g., via one of the lips (16, 116) of the gasket 20). If any fluid or coolant is present in the channel (17, 117, 217), the former dry air gap of the channel (17, 117, 217) becomes a fluidic path that may be referred to as an auxiliary coolant flow path 14, a weep path, or a vent path. The auxiliary coolant flow path 14, a weep path, or a vent path vents or directs coolant away from the electronics cavity region (12, 112) in the event that the coolant or other fluid breaches one of the lips (16, 116, 216, 316) of the gasket, for example.

In an alternate embodiment, the gasket 20 may comprise two separate elastomeric lip seals (e.g., with generally rectangular cross sections or generally L-shaped cross sections) that are spaced apart in the X-Y plane (e.g., defined by the intersection of the X-axis 105 and Y axis 107) by an intermediate spacer of lower height (e.g., along the Z-axis 115) than the lip-seal height of lip seals in a single common (e.g., wide) recess in a flange of the housing (102, 106)) to define a primary channel (17, 117, 217) in an air gap between the two separate elastomeric seals.

In yet another alternate embodiment, the gasket 20 may comprise two separate elastomeric lip seals (e.g., with generally rectangular cross sections or generally L-shaped cross sections) that are in a common recess and spaced apart in the X-Y plane (e.g., defined by the intersection of the X-axis 105 and Y axis 107) by an air gap between the two separate elastomeric lip seals.

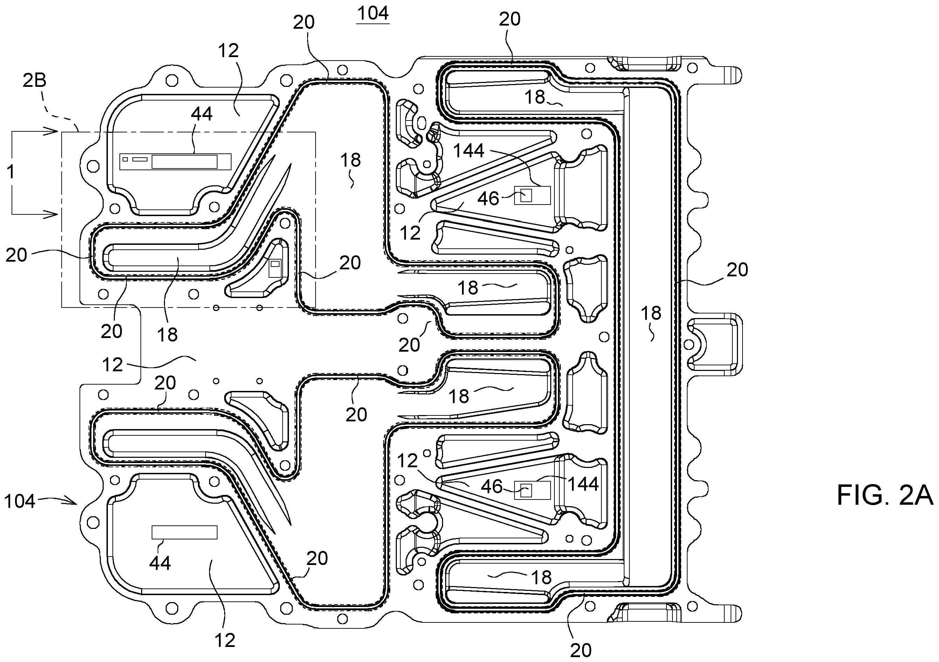

FIG. 2A shows a plan view of the electronic assembly 211 with a second housing portion 102 removed to show an interior or top of the first housing portion 106. In FIG. 2A, reference number 1 shows how the view of the cross-section of FIG. 1 relates to FIG. 2A. Like reference numbers in FIG. 1 and FIG. 2A indicate like elements or features.

FIG. 2A provides illustrative examples of one or more electronics cavity regions 12 of the housing (e.g., first housing portion 106) that are spaced apart from one or more coolant cavity regions 18. The gasket 20 or set of gaskets 20 track circuitous or serpentine paths between the electronics cavity regions 12 and the coolant cavity regions 18. The gasket 20 or set of gaskets 20 overlines a flange, with or without a recess for accepting the gasket 20, that tracks a circuitous or serpentine paths between the electronics cavity regions 12 and the coolant cavity regions 18. Further, the gasket 20 or set of gaskets 20 provides fluidic isolation and reliable sealing between the electronics cavity regions 12 and coolant or fluid within the coolant cavity regions 18.

FIG. 2B shows an enlarged portion of FIG. 2A in the rectangular region 2B of FIG. 2A. In FIG. 2B, the gasket 20 is bounded on a first side (e.g., along coolant seal region 26) by one or more coolant cavity regions 18 and on a second side, which is opposite the first side, (e.g., along an electronics seal region 24) by one or more electronics cavity regions 12. At the first side, the gasket 20 is configured to seal or isolate the coolant within the coolant cavity region 18: (a) from the primary channel 17 and (b) from the electronics cavity region 12 during normal or ordinary operation of the electronics assembly (211, 311). Similarly, at the second side, the gasket 20 is configured to seal or isolate the coolant within the coolant cavity region 18: (a) from the primary channel 17 and (b) from the electronics cavity region 12 during normal or ordinary operation of the electronics assembly (211, 311).

In some configurations or alternate configurations during normal state of operation, the coolant cavity region (18, 118) can be located on the first side of the gasket 20 or the second side of the gasket 20, where the electronics cavity region (12, 112) is located on an opposite side of the gasket 20 from (e.g., with respect to) the coolant cavity region (18, 118). However, during a breached state of operation, seeping, leaking or hydraulic breach of coolant occurs (e.g., at one or more points or segments) along breached lip (e.g., 16, 116, 216, 316) of the (coolant) seal region 26; hence, from the coolant cavity region 18, (leaking) coolant is routed and retained within the primary channel 17 of the gasket 20 toward the exit aperture 140, which comprises an opening in the sidewall of the non-breached lip (e.g., 16, 116, 216, 316) or, alternately, an opening in the bottom wall 30 of the channel 17. Further, except for any exit aperture 140 in the wall (e.g., sidewall or lip) of the gasket (20, 120), the non-breached lip (16, 116) remains intact at the (electronics) seal region 24 to prevent the flow of coolant into the electronics cavity region 12 (e.g., potentially aided by the pressure relief afforded by the exit aperture 140 that is in communication with a relief region 165, alone, or in conjunction with vent opening 22).

In FIG. 2B, the concept of the pressure relief path 114 is generally illustrated by the arrows, where the fluid or coolant generally flows: (a) from the coolant cavity region 18 to the exit aperture (40,140), and (b) from the exit aperture (40, 140) to the vent opening 22, which in turn drains the fluid, coolant, or lubricant by gravity to a reservoir or container which can be emptied or disposed of as service is needed. Further, in FIG. 2B, the concept of the pressure relief path 114 does not apply during normal state of operation no fluid or fluid flows into the vent opening 22 and the channel (17, 117, 217) of the gasket is dry. However, the concept of the pressure relief path 114 applies during leakage state where one of the lips (16, 116) of the gasket 20 is breached by the ingress of coolant, fluid or lubricant. The arrows 114 of FIG. 2B could be located at any leaking or seeping point or segment of the lip (16, 116), which faces the coolant cavity region 18, and allows the coolant, fluid or lubricant to enter the channel (17, 117,217) of the gasket so that it can be diverted by the exit aperture (40, 140) to the vent opening 22.

FIG. 3 shows an enlarged portion of FIG. 2B in the rectangular region 3 of FIG. 2B. Like reference numbers in any two drawings indicate like elements or features.

FIG. 3 shows a breached state of the gasket 20 at a wall or lip (16, 116) that is facing the coolant cavity region 18. Accordingly, as indicated by arrows that represent auxiliary coolant flow 14, first, coolant or fluid flows into the channel 17 and, second, the coolant or fluid flows within the central channel 17, where it is diverted initially to the exit aperture 140 and subsequently to the drain hole 22 to protect the electronic components (46, 146) within the electronics cavity region 18 from the influx or ingress of moisture, coolant, fluid or lubricant from the coolant cavity region 18. In the absence of the gasket 20, with its accompanying channel (17, 117, 217) and exit aperture (40, 140), to divert moisture, coolant fluid or lubricant from the electronics cavity region (12, 112) in accordance with the disclosure, the ingress or influx of moisture, coolant, fluid or lubricant that conducts electricity would tend to make the electronic components (46, 146) and circuit boards (44, 144) susceptible to short-circuits, permanent damage, or inoperability of electronic circuits, among other things.

FIG. 4 shows an enlarged portion of FIG. 2B in the rectangular region 3 of FIG. 2B with arrows indicating one possible flow path of coolant along the coolant flow path 114 or weep path. In FIG. 3, the auxiliary coolant flow path 14 is illustrated as unidirectional within the channel 17 of the gasket 20, whereas in FIG. 4, the auxiliary coolant flow path 14 is illustrated as by bidirectional, based on the arrow, that track the channel 17 of the gasket 20.

In some configurations, auxiliary coolant flow path 14 (e.g., weep path) routes fluid or coolant to a vent opening 22 via the exit aperture (40, 140) of protect the electronic components (46, 146) in the enclosure or electronic assembly 211. In other configurations, the auxiliary coolant flow path 14 routes fluid or coolant to a removable container, which can be emptied from time to time by a vehicle user or technician.

For example, the electronics assembly (211, 311) is configured with an auxiliary coolant flow path 14 (e.g., weep path) or venting path along the gasket 20 or gasket recess 21 to prevent a cascaded compromise (e.g., cascaded breach) of a dual lip 16 seals or multiple lip seals placed in series, where once the initial lip (16, 116) seal is compromised the breaching fluid or coolant could start to pressure (with possibility of breaching) the next lip (16, 116) seal or next sealing surface. Further, the auxiliary coolant flow path 14 (e.g., weep path) is configured where an air pressure or hydraulic pressure at an exit aperture (e.g., 40, 140) or outlet of the weep path or auxiliary coolant flow path 14 is equal to or lower than an air pressure of an electronics cavity region 112 (e.g., electronics air pocket) or any hydraulic pressure (if any suitable dielectric fluid is normally kept) in the electronics cavity region 12.

In some embodiments, the electronics cavity region 112 (e.g., electronics air pocket) is configured to contain or house one or more circuit boards 44 with heat-generating components (46, 146), whereas the coolant cavity region 118 is configured to contain coolant under hydraulic pressure within a target hydraulic pressure range. Prior to a breach of one or both lips 16 of the gasket 20, the auxiliary coolant flow path 14 (e.g., weep path) can be maintained at a lower pressure (e.g., lower air pressure, lower hydraulic pressure) than that of electronics cavity region (12, 112) (e.g., an electronics air pocket) that holds or houses one or more circuit boards 44 with heat-generating electronic components, 46, 146 to facilitate the venting or routing of coolant or liquid to an exit or container upon breach of one lip 16 (e.g., wall) of the gasket 20, instead of building pressure onto the next lip 16 seal (e.g., remaining lip seal that separates the primary channel 17 from the electronics cavity region 12).

In one embodiment, the gasket 20 can be configured as a single gasket 20 with dual lips 16 or dual walls for sealing or isolating electronics cavity that houses electronics from lubricant, fluid or coolant. However, in an alternate embodiment, a pair of parallel gaskets 20 (e.g., inner gasket and an outer gasket) can replace the single gasket 20, where each one of the parallel gaskets 20 has respective outer lips, outer walls, outer seals or outer sealing edges with a channel 17 between the respective outer lips, outer walls, outer seals or outer sealing edges. Further, if the two parallel gaskets are spaced apart by an intermediate gap, the intermediate gap and the exposed surface of the electronic assembly within the gap may define an auxiliary channel or primary alternate primary channel 17 between the two gaskets 20 that route coolant, liquid, or lubricant along the auxiliary channel. For example, in an alternate embodiment, the two gaskets comprise inner gasket and an outer gasket, where an outer perimeter of an outer gasket tracks the inner perimeter of an inner gasket by the gap (e.g., radial gap) within a range or tolerance.

In another alternate embodiment, the above pair of parallel gaskets 20 are integrally formed to establish an integral dual gasket having two or three central longitudinal channels between the walls of the parallel gaskets.

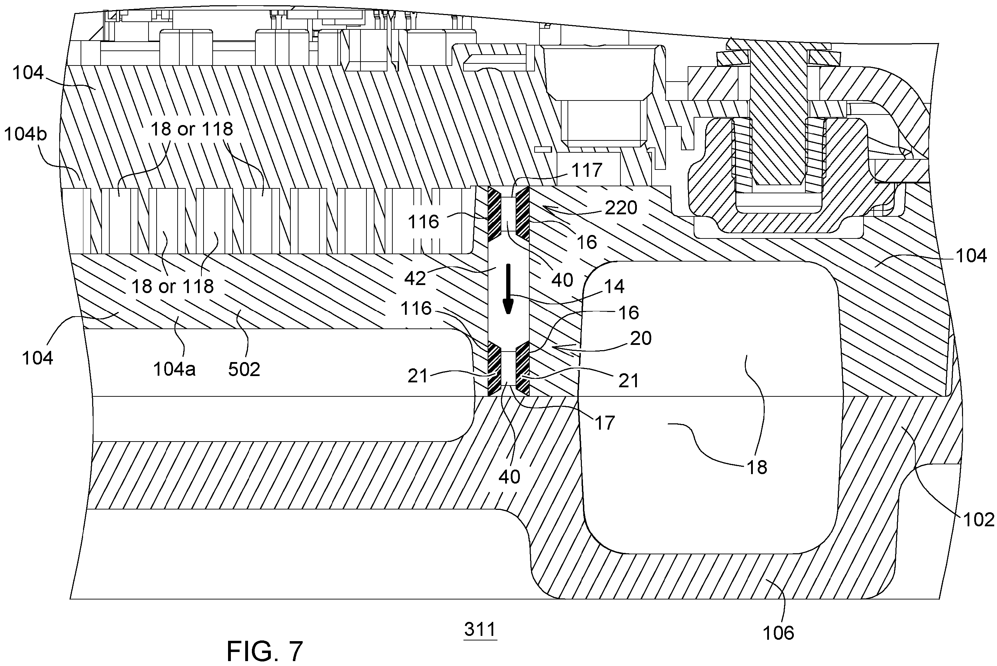

FIG. 5 and FIG. 7 each show a cross-section of an electronics assembly 311 comprising a first housing portion 106 and a second housing portion 102 in the region of a secondary channel 42, such as a venting or drain channel (e.g., vertical channel with a longitudinal path along the Z axis 115). The secondary channel 42 provides a hydraulic connection for any coolant or any fluid present (e.g., channel 17 is generally dry during normal operation of the electronic assembly) to flow between a primary channel 17 of a first gasket 20 (e.g., primary gasket) and an alternate primary channel 117 of a second gasket 220, where the primary channel 17 and the alternate primary channel 117 support the flow of coolant or fluid at different vertical levels (e.g., along the Z-axis 115) of the electronic assembly (e.g., to support diversion or routing of any leaking coolant or fluid to the exit aperture (40, 140) and away from the electronics cavity region (12, 112). For example, the primary channel 17 of the first gasket 20 may generally direct coolant to flow in a first plane (e.g., first X-Y plane), whereas the alternate primary channel 117 of the second gasket 220 may generally direct coolant to flow in a second plane ((e.g., second X-Y) that is spatially separated from the first plane by a substantially uniform distance along the Z axis 115.

FIG. 6 shows a plan view of the electronic assembly 311 with a second housing portion 102 removed to show an interior or top of the first housing portion 106 as viewed along reference line 6-6 of FIG. 5. In FIG. 6, the first gasket 20 has an aperture 40 in the bottom 30 (e.g., bottom wall or floor) of the first gasket 20 between two outer lips (16, 116), where any coolant can be directed or diverted from the primary channel 17 of the first gasket 20 vertically within the secondary channel 42 to alternate primary channel 117 of the second gasket 220.

In some configurations, a gasket 20 has an exit aperture (40, 140) or hole in the primary channel 17 (or alternate primary channel) to redirect coolant along the auxiliary coolant flow path 14 (e.g., weep path) that routes coolant or fluid through the aperture (40, 140) or hole and away from the electronics cavity region 12, and away from the electronic components (46, 146) that are susceptible to or vulnerable to damage (e.g., short circuits) from electrically conductive coolant or fluid. Accordingly, the hole or exit aperture (40, 140) in the primary channel 17 (or alternate primary channel) can connect segments of a weep path or auxiliary coolant flow path 14, such as weep path segments of one or more primary and secondary gaskets. Further, the primary and secondary gaskets that are configured to communicate hydraulically with each other can be located in a common plane (with the gasket 20) or in one or more different planes (e.g., different vertical planes separated by a vertical dimension, along the Z axis 115). The auxiliary coolant flow path 14 or weep path tends to reduce the risk of coolant getting into the electronics cavity region 12, or contacting the (energized) heat-generating electronic components (46, 146) in the electronics cavity region 12 (which could lead to short-circuits between terminals of the electronic components 46, 146, among other possible malfunctions).

In some embodiments, exit apertures (40, 140) or other openings are placed to allow coolant to flow between or among primary channels of one or more gaskets 20. In alternate embodiments, Tee or "Y" transitions or junctions route the coolant through channels of various gaskets, where the channels may be configured in parallel or series with each other.

In FIG. 3 and FIG. 4, an exit aperture 140 in the side-wall or lip of a gasket 20 or in FIG. 5 and FIG. 6 an aperture 40 in the bottom wall (e.g., floor) of a gasket 20, alone, or together with a secondary channel 42 (e.g., vertical channel of FIG. 5 or FIG. 7) can be configured (e.g., in series) to create auxiliary coolant flow path 14 or weep path with minimal space, such as within an electronics assembly (211, 311), such as an inverter, converter, or power electronics. For example, the exit apertures (40, 140) and secondary channels 42 can be used to connect hydraulically, coolant flow paths 14 or weep paths on same planes and different planes (e.g., distinct X-Y plans separated by an uniform displacement in the Z-axis 115 direction of the Cartesian coordinate axes 103) of the electronics assembly, where ultimately the coolant can exit device or move to a removable container that can be emptied later.

Advantageously, the gasket 20 with dual lips 16 can save space within the electronics assembly (211, 311) in comparison to a configuration with two separate gaskets 20, such as an inner gasket 20 and an outer gasket 20 (which are spaced apart from each other) with an intermediate weep channel in the housing.

The electronics assembly (e.g., 211, 311) of this disclosure facilitates an auxiliary coolant flow path 14 (e.g., weep path), a vent path or routing path to allow moisture or coolant that has passed one lip 16 of the gasket 20 to exit the assembly or to move coolant to a container or designated collection volume that can collect the coolant. The electronics assembly is well-suited to move fluid away from the electronics cavity region 12 seal to the outside of the component or to a storage location.

For example, the electronics assembly is configured with a relatively low pressure auxiliary coolant flow path 14 (e.g., weep path) or venting path along the gasket 20 or gasket recess 21 (with respect to the pressure of the electronics cavity region 12) to prevent cascaded compromise of a dual lip seals or multiple lip seals placed in series, where once the initial lip 16 (its lip seal, or its seal) is compromised the breaching fluid or coolant will start to pressure onto the next lip 16 (its lip seal, or its seal) or next sealing surface. The relatively low pressure auxiliary coolant flow path 14 (with respect the interior pressure (e.g., air, fluidic or hydraulic pressure) of the electronics cavity region 12) facilitates the venting or routing of coolant or liquid to an exit or container, instead of building pressure onto the next lip 16 (or its seal).

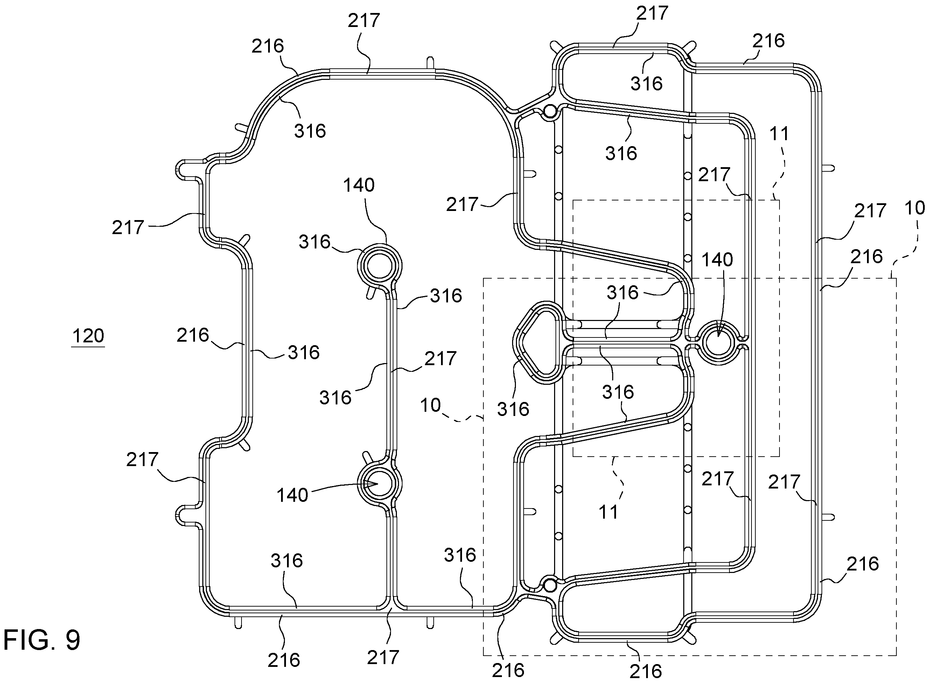

FIG. 9 shows a plan view of one embodiment of a gasket 120, where the gasket 120 is illustrated as separate from or removed from the electronic assembly (e.g., 211). The gasket of FIG. 9 can be defined as a path or sealing path (e.g., circuitous path) that comprises curved segments and linear segments that are connected end to end to form the gasket 120. The path, shape and size (e.g., dual walled gasket 120 with a central, longitudinal channel 217) of gasket 120 corresponds to or is related to one or more of the following: (a) perimeter of a first housing portion; (b) a perimeter of the second housing portion; (c) a sealed boundary to isolate fluid or coolant (e.g., under target range of hydraulic pressure) within coolant chambers, central channel(s) 217, coolant regions, coolant cavities, or coolant volumes within the electronic assembly from non-coolant regions (e.g., electronic chambers, electronic regions electronic volumes to house electronic circuit boards and components); (d) a sealed boundary to isolate air (e.g., at ambient pressure or charged or pressurized within a target range of air pressure) and electronic circuits, electronic components, electrical circuits and electrical components from fluid or coolant, where electronic chambers, electronic regions electronic volumes house electronic circuit boards, electronic circuits, electrical circuits, and electrical or electronic components in an air-filled volume; (e) a sealed boundary to isolate transmission fluid or oil (e.g., under target range of hydraulic pressure) within coolant chambers, central channels 217, coolant regions, coolant cavities, or coolant volumes within the electronic assembly from non-coolant regions (e.g., electronic chambers, electronic regions electronic volumes to house electronic circuit boards and components); and (f) a sealed boundary to isolate air (e.g., at ambient pressure or charged or pressurized within a target range of air pressure) and electronic circuits, electronic components, electrical circuits and electrical components from hydraulic fluid or oil, where electronic chambers, electronic regions electronic volumes house electronic circuit boards, electronic circuits, electrical circuits, and electrical or electronic components in an air-filled volume.

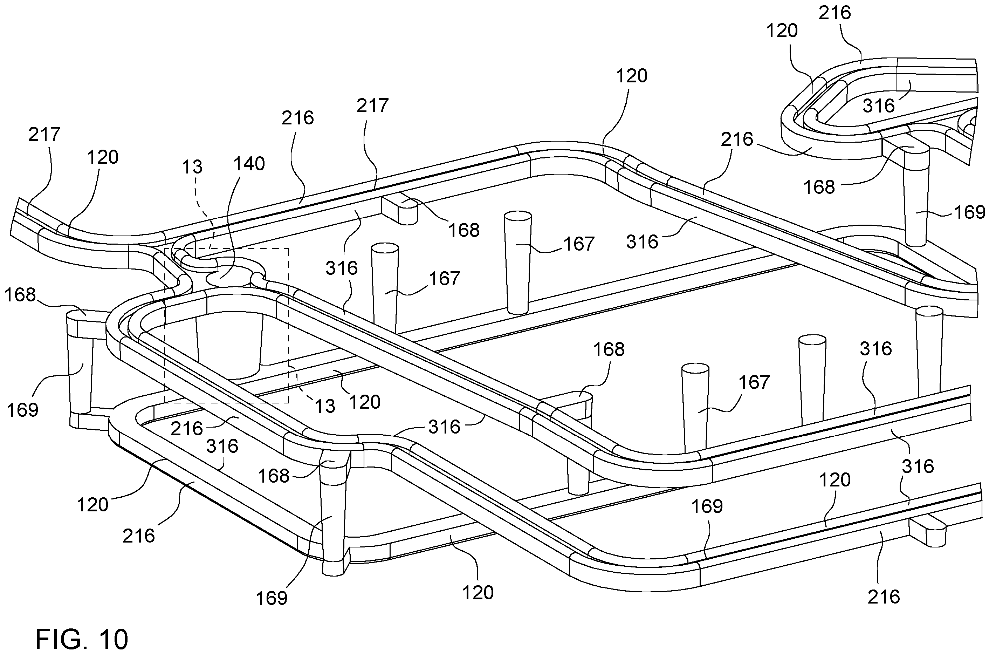

In FIG. 9, the gasket 120 has a cross-section with an outer wall 316 (e.g., an outer lip), an outer wall 216 (e.g., an outer lip) and a central channel 217 (e.g., central longitudinal channel for diverting coolant). The channel 217 may track curved segments or generally straight segments as viewed in a plan view. Further, the gasket 120 also has pedestals (167, 169 in FIG. 10) that may engage or extend into vias (e.g., for mechanical retention of gasket 120) that are present in the first housing portion 102, the second housing portion 106, any circuit board (44, 144), or other components of the electronic assembly (211, 311). As illustrated in FIG. 9, there are several features that allow leaking fluid or coolant to flow into and through a central channel 217 (e.g., if one or more walls of the gasket 120 are breached) to a collection chamber or collection container (e.g., via an exit aperture (40, 140) in the wall or lip (216, 316) of the gasket 120 and one or more vertical channels in the gasket 120 and/or in the housing (102, 106) of the electronic assembly). The central channel 217, alone or in cooperation with any exit aperture (40, 140), is configured to perform analogous functions to any channel (17, 117) in other embodiments set forth in this disclosure for a breached state of operation of the outer lips or outer walls (216, 316), such as conveying or directing fluid or coolant originating from the coolant cavity region (18, 118) away from the electronics cavity region (12, 112). Further, the outer walls (216, 316) of the gasket 120 are configured to perform analogous functions to the outer lips (16, 116) in other embodiments set forth in this disclosure, such as protection of the electronic components (12,112) in the electronics cavity region (12, 112) from the ingress of coolant, fluid, or lubricant (e.g., during normal state of operation of the gasket 120 or during a partially breached state of one wall or lip of the gasket 120).

In one embodiment, the gasket 120 is formed by dispensing uncured elastomer, polymer, or plastic as a bead or extruded material that adheres to the surface or within a slot, recess or groove in a flange of a housing (102, 106) or other portion of the electronic assembly (211, 311), where the dispensed or extruded cross section if the bead has at least one channel 217 (e.g., central channel or longitudinal channel). Further in some embodiments, a removable mold, removable female mold, removable male mold, removable frame, or removable skeleton is configured to form, retain, or mold one or more channels 217, vertical channels (e.g., drains with exit aperture 140), or other mechanical features in the dispensed or extruded cross section of the gasket 120. After the dispensed or extruded elastomer, polymer or plastic cures, partially or completely, in situ (e.g., becomes cross-linked), the removable mold, removable female mold, removable frame or removable skeleton is removed to reveal the gasket 120 with the desired shape, size and cross section to seal the portions of the electronic assembly and to provide a path for the flow or routing of possible fluid (e.g., leakage or leaking fluid in the channel 217 to a (collection) container or exit aperture 140 or exit port).

In certain embodiments, the cured gasket 120 has pedestals (167, 169 in FIG. 10) or vias between different layers of the electronic assembly to hold or retain the gasket 120 in place with respect to the electronic assembly (211, 311). When the gasket 120 is formed by dispensing uncured elastomer, polymer or plastic as bead or extruded material, the dispensed material can flow into the voids or vias in the housing, layers, circuit boards (44, 144), or portions of the electronic assembly (211, 311). After the elastomer, polymer or plastic is cured within the via or pedestal, the cured elastomer, polymer or plastic bead or extruded material that forms that gasket 120 is held in place, secured or retained (e.g., mechanically) by the vias or pedestals.

In an alternate embodiment, the gasket 120 is adhesively bonded to the housing, layers, circuit boards, or other portions of the electronic assembly to hold, secure, or retain the gasket 120.

FIG. 10 shows an enlarged rectangular region (10) of the plan view of FIG. 9 of the gasket. Like reference numbers in FIG. 9 and FIG. 10 indicate like features, elements or structures. The gasket 120 further comprises additional features for retaining the gasket 120 with respect to one or more portions or surfaces of the electronic assembly as follows: (a) transverse projections 168, such as nubs, where the projections 168 may engage a groove, recess or channel in a portion of the electronic assembly, and (b) pedestals (167, 169) that may engage a via or vertical opening in a portion of the electronic assembly. Some pedestals 169 may be attached, connected to or adhesively bonded to projections 168 on both ends to retain, hold or lock the gasket 120 in place with respect to the electronic assembly (211, 311), its housing (102,106), or portions of the electronic assembly (211, 311).

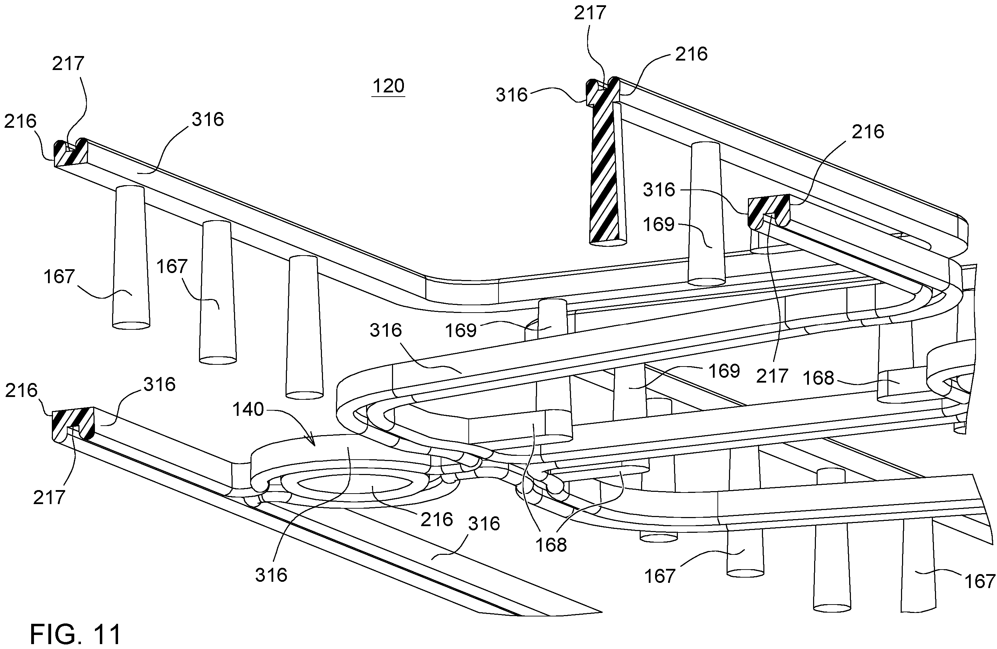

FIG. 11 shows an enlarged rectangular region (11) of the plan view of FIG. 9 of the gasket 120. Like reference numbers in FIG. 9 through FIG. 13, inclusive, indicate like features, elements or structures.

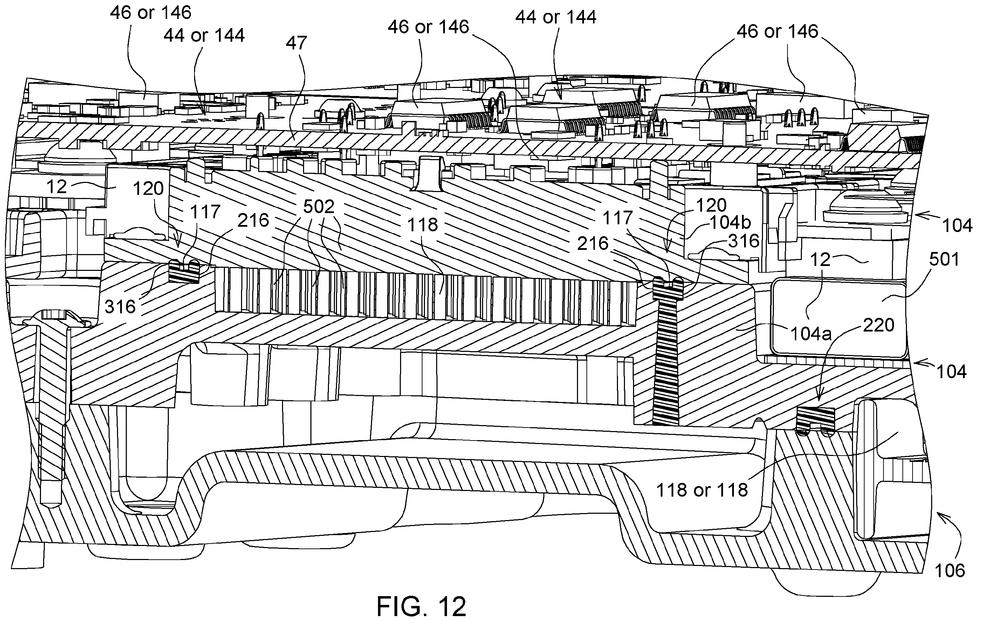

FIG. 12 shows a cross-section of the gasket of FIG. 11 installed (or dispensed) in the electronic assembly, where the electronic assembly of FIG. 12 is cut-away to reveal a cross-section of the gasket 120 in alignment with FIG. 11. As illustrated in FIG. 12, one or more circuit boards (44, 144) are housed in or mounted in the electronics cavity region (12,112), where each circuit board (44, 144) may be populated with electronic components (46, 146) or electrical components. Each circuit board (44, 144) may comprise a dielectric substrate with conductive circuit traces on one or both sides for mounting electronic components (46, 146). The electronic components (46, 146) may comprise heat-generating components, such as semiconductor devices, power switching transistors, electronic data processors, system-on-chips (SOC), microchips, or the like. The gasket 120, or its walls (216, 316), retain, isolate and seal coolant within coolant cavity regions 118 of the electronic assembly such that coolant may be circulated through the electronic assembly for dissipating heat or thermal energy from the heat generating electronic components (e.g., 46, 146). The gasket 120, or its walls (216, 316), retain, isolate and seal coolant within lubricant cavity regions of the electronic assembly or any lubricant bath, pan, or reservoir (e.g., of a gearbox or transmission) in which the electronic assembly is installed or housed, such that the lubricant (e.g., transmission fluid or oil) may be circulated around, near, adjacent or through a portion the electronic assembly (e.g., for dissipating heat or thermal energy from the heat generating components).

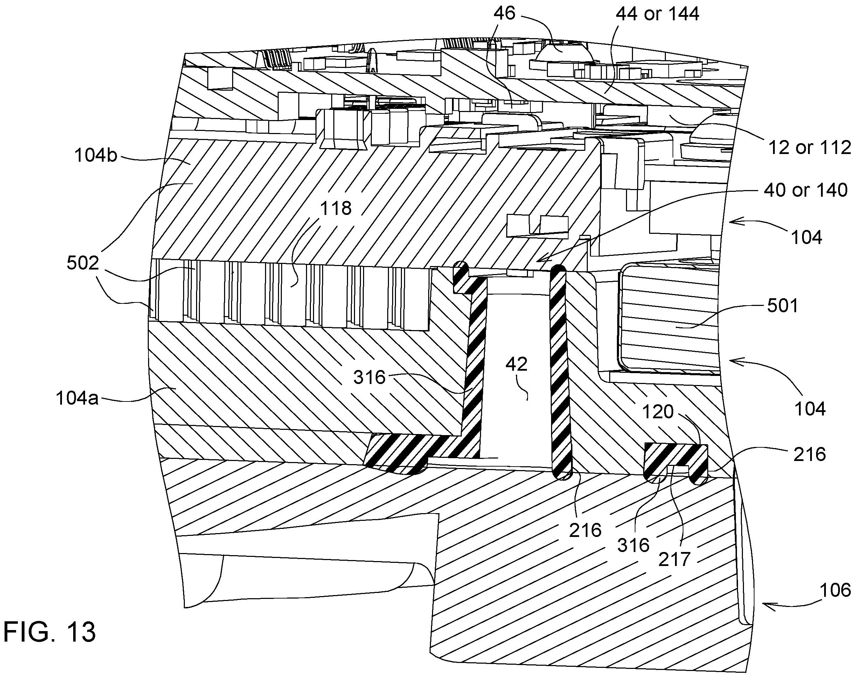

FIG. 13 shows a cross-sectional portion of the gasket 120 of FIG. 10 in the region 13, where the gasket 120 is installed (or dispensed) in the electronic assembly, where the electronic assembly is cut-away to reveal a perspective view of a vertical channel 42 or drain within the gasket 120. The coolant cavity region 118 (e.g., coolant cavity channel) is isolated or sealed at an outer wall 316 of gasket 120. If the outer wall 316 is compromised near the seam between first housing portion 106 and the second housing portion 102, the leaking coolant may track or flow within the channel 117 until it is routed to an exit aperture 140.

A first outer lip or outer lip (216, 316) of the gasket 120 may define a boundary of the electronics cavity region (12, 112); such first outer lip that faces or bounds the electronics cavity region can be referred to as an electronics-cavity-adjoining lip. A second outer lip (216, 316) or outer lip (16, 116) of the gasket 20 may define a boundary of the coolant cavity region 18; such second outer lip that faces or bounds the electronics cavity region 18 can be referred to as a coolant-cavity-adjoining lip. The first outer lip or the second outer lip (16, 116) may also face or bound a lubricant cavity region, such as the interior volume of the transmission or the transmission pan region, to isolate the lubricant (e.g., oil or hydraulic fluid) from an electronics cavity region (12, 112), a coolant cavity region (18, 118), or both.

In one embodiment, the electronics cavity region (12, 112) is filled with air, such as air at ambient air pressure of the environment outside of the electronics assembly or its electronics cavity region (12, 112).

In an alternate embodiment, the electronics cavity region (12, 112) is filled with pressurized air or compressed air (e.g., at an air pressure above the ambient air pressure) provided by an air compressor connected to an input port in communication with the electronics cavity region and an exit port coupled to a pressure relief valve (e.g., 467) or a pressure regulator valve that vents pressurized air to the ambient environment if the pressurized air within the electronics cavity region exceeds a maximum threshold, where the maximum threshold is commensurate with a hydraulic pressure range (e.g., target design hydraulic pressure range, an average or mean hydraulic pressure and its standard deviation, or an observed hydraulic pressure range) of the coolant against, adjoining or threatening, or retained by any coolant facing wall (216, 316) of the gasket 120.

In another alternate embodiment, the electronics cavity region (12, 112) is filled with (e.g., injection molded with) a dielectric potting compound, a dielectric elastomer, a plastic encapsulation or a polymeric encapsulation to protect the electronic components from the ingress of any coolant, fluid, or lubricant that could breach or does breach the seal of the gasket.

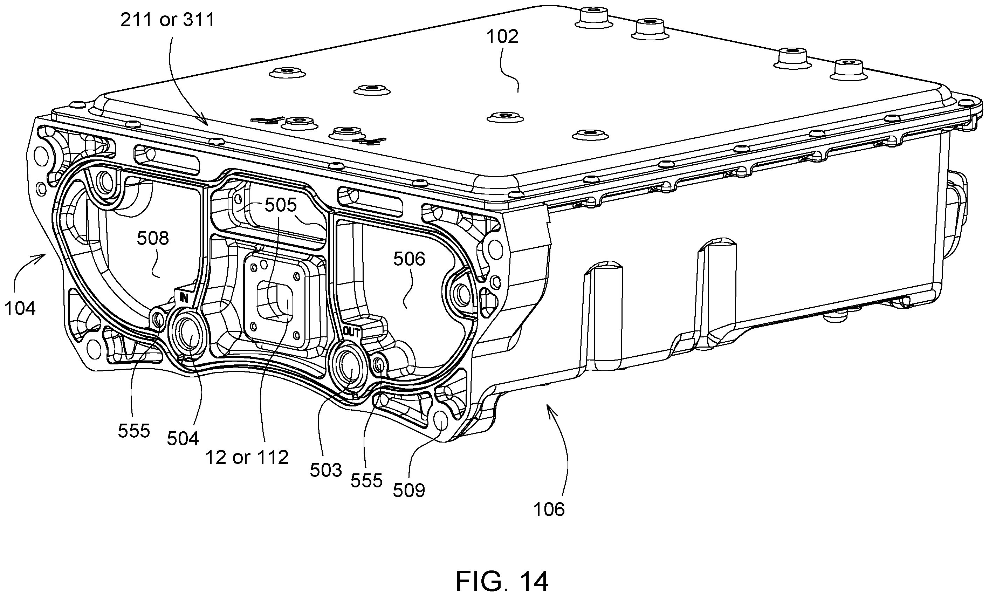

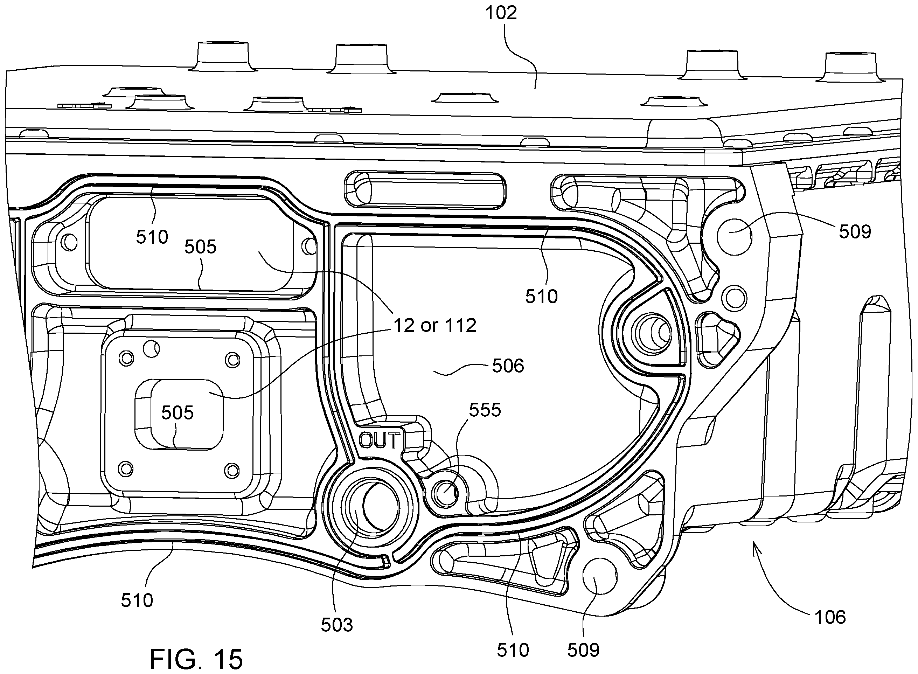

FIG. 14 and FIG. 15 show one embodiment of a perspective end view of the electronic assembly (211, 311), where electrical openings 505 and recesses (506, 508) are revealed. In FIG. 14 and FIG. 15, the electronics assembly (211, 311) has an end of the first housing portion 106 with one or more recesses (506, 508), where each recess may be configured to communicate with an exit aperture (40, 140) that supports the direction of leaking fluid, coolant, lubricant or oil to the recess via an overflow linkage channel 555. Each recess (506, 508) is associated with a perimeter seal or gasket that may be aligned to seat or fit into seal groove or seal channel 510.

A primary overflow vessel (464, 513) is defined partially by or bounded by one or more recesses (506, 508) and may form one or more chambers or containers. The primary overflow vessel (464, 513) is capable of receiving coolant from the exit aperture (40, 140) via an overflow linkage channel 555.

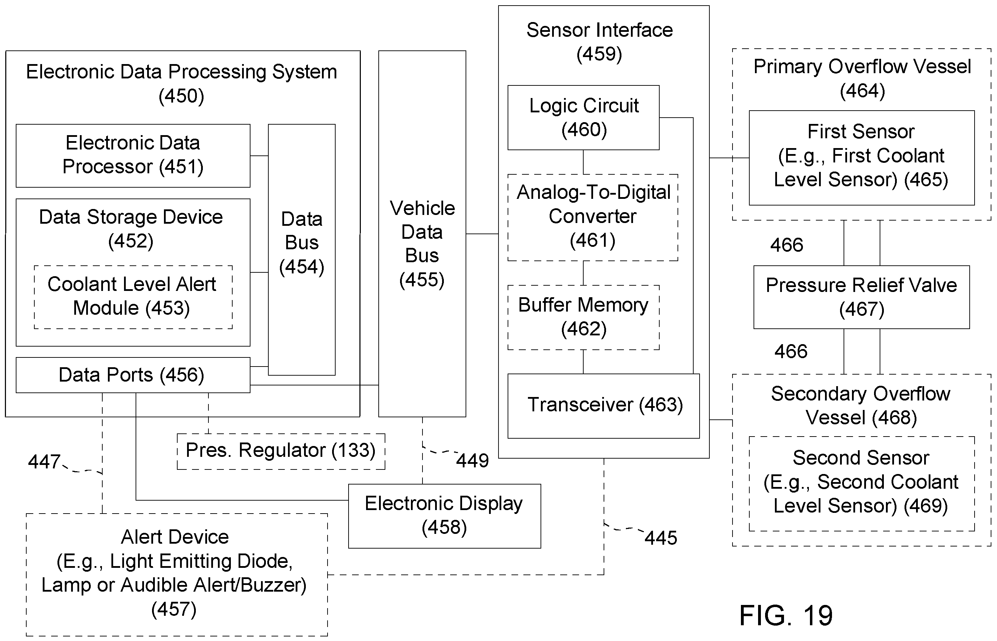

The electrical connector openings 505 in the first housing portion 106 provide mounting areas for one or more electrical connectors 557, which may comprise data ports that provide electrical signals or data communications between the electronic assembly (211, 311) and the vehicle data bus 455 (in FIG. 19) or other an electronic data processing system 450. The electrical connector openings 505 provide access to the interior of the electronic assembly; namely, the electronic cavity region (12 or 112). The electronic assembly has bores 509 for connection or mounting of the electronic assembly (211, 311) to other components (e.g., transmission or gearbox housing 511) of a vehicle, or to the vehicle frame or vehicle body via one or more fasteners.

FIG. 14 and FIG. 15 shows one embodiment of a perspective end view of the electronic assembly, where one or more recesses can communicate with an exit aperture for coolant overflow or leakage.

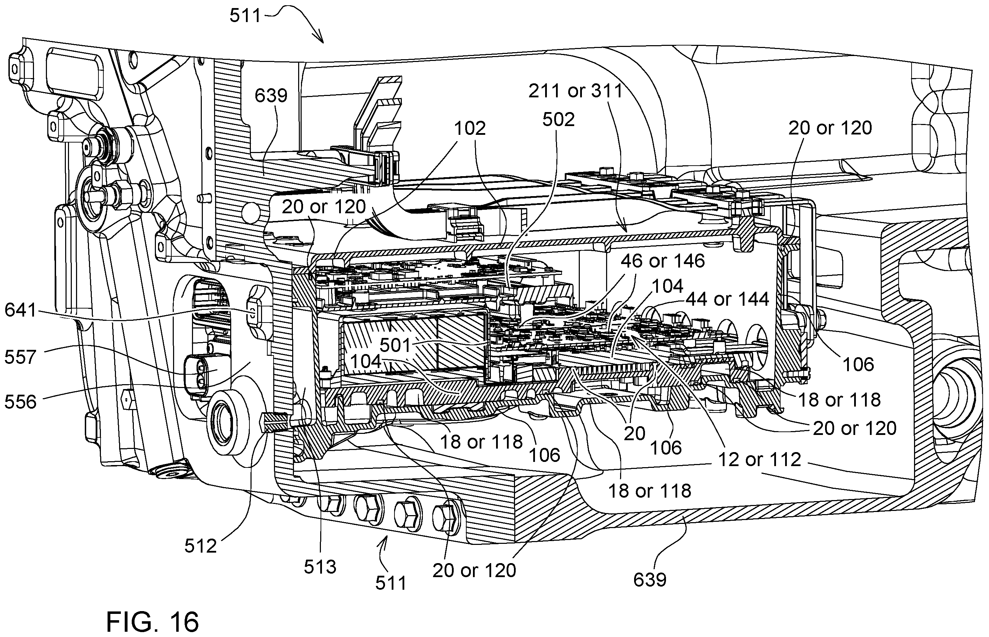

FIG. 16 shows one embodiment of a cross-sectional perspective view of the electronic assembly (211, 311), where the electronic assembly is connected to and housed within or outside a transmission housing or gearbox housing 511. The electronic assembly (211, 311) of FIG. 16 is similar to the electronic assembly of FIG. 14 and FIG. 15, except the electronic assembly of FIG. 16 is fastened or connected to the transmission housing 511 via one or more fasteners that engage bores 509, such as threaded bores in the electronic assembly (211, 311) Like reference numbers in any two drawings of the document indicate like elements or features.

In FIG. 16, the electronic assembly (211, 311) illustrates a removable terminating plug 512 (e.g., inspection plug or service plug) in a threaded bore of the transmission housing 511 or gearbox housing, which can be used by a technician, operator, or another person to send an optical inspection camera into the primary overflow vessel that is defined by the recess (506, 508) in the housing of the electronic assembly (211, 311) together with a wall 556 (e.g., outer wall) of the transmission housing 511.

In one embodiment, the primary overflow vessel (464, 513) is defined by a recess (506, 508) in an end of the first housing portion 106, a wall of a transmission housing 511, and an intermediate seal between facing or mating surfaces of first housing portion 106 and the wall. The recesses (506, 508) are sealed to the wall 556 via an intervening or intermediate seal. For example, the intermediate seal may reside, fit or lay within a seal recess groove 510 in the end of the housing of the electronic assembly. The overflow linkage channel 555 is disposed between the recess (506, 508) and the exit aperture (40, 140).

Within the housing 106 of the electronic assembly (211, 311), a set or bank of capacitors 501 is configured to store electrical energy and to filter the direct current (DC) bus. Meanwhile, in some embodiments, the thermal plate 502 (e.g., heat sink) may have one or more semiconductors, power switching transistors, or other heat-generating electronic components (46 or 146) mounted on a first side of the thermal plate 502; a second side of the thermal plate 502, which is opposite the first side, may be exposed to coolant circulating within a electronic coolant cavity (18, 118) via the (electric) pump 110 and heat exchanger 113 that are connected to coolant outlet 503 (e.g., coolant outlet port) and coolant inlet 504 (e.g., coolant inlet port). In some configurations, the first side of the thermal plate 502 is generally planar, whereas the second side of the thermal plate 502 has fins, studs, pins or other protrusions to increase thermal dissipation to the coolant or circulating coolant. The second side of the thermal plate 502 may form part of the coolant cavity region (18, 118).

In one embodiment, an optional adjustable pressure regulator valve 133, alone or together with an integral coolant pressure sensor, is or are coupled in series with the tubing 109 (e.g., coolant lines) of the coolant system; where the adjustable pressure regulator valve 133 is configured to regulate, reduce or limit an observed pressure of the coolant circulating within one or more coolant cavities of the inverter or electronics assembly (211, 311) upon detection of a leak in the gasket (20, 12) or presence of coolant in the overflow vessel. The optional adjustable pressure regulator valve 133, alone or together with a coolant pressure sensor, are coupled to the data ports 456 of the electronic data processing system 450, where the electronic data processor 451 can execute software instructions to regulate, reduce or limit an observed pressure of the coolant circulating within one or more coolant cavities of the inverter or electronic assembly (211, 311) upon detection of a leak in the gasket (20, 12) or presence of coolant in the overflow vessel. The optional adjustable pressure regulator valve 133 is optional as indicated by the dashed lines in FIG. 1; the observed pressure of the coolant can be detected by an optional coolant pressure sensor in series with the adjustable pressure regulator valve 133.

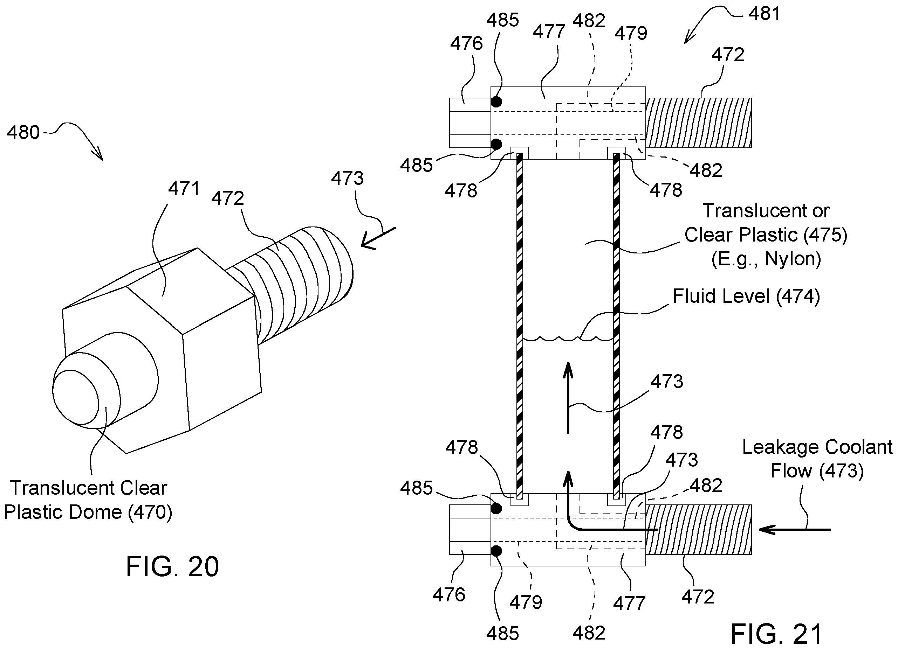

In an alternate embodiment, the removable terminating plug 512 may be removed from the threaded bore of the terminating plug 512 may be replaced by a visual inspection device or inspection window device 480 (in FIG. 20) that is screwed into the open threaded bore left by removal of the terminating plug 512. The visual inspection device 480 engages a threaded bore in the wall of the transmission housing 511 to support visual inspection of fluid or coolant in the primary overflow vessel (e.g., 465), where such visual inspection device 480 may engage one threaded bore in the wall of the transmission housing 511 and a first sensor 464 may engage another threaded bore in the wall of the transmission housing 511.

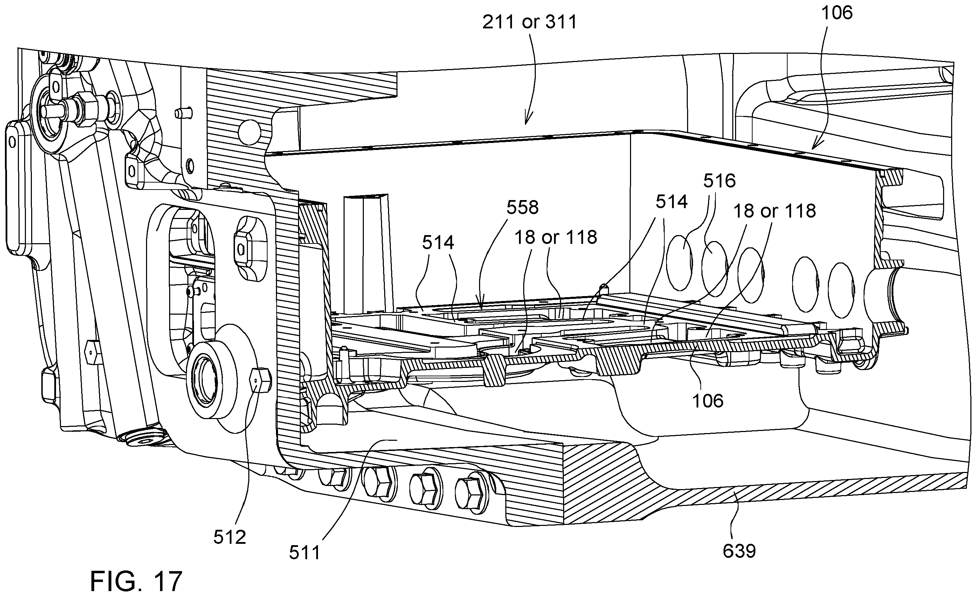

FIG. 17 shows one embodiment of a cross-sectional, perspective view of the housing of the electronic assembly (211, 311) with the circuit board (44, 144), electronic components (46, 146), and other components removed to reveal the interior 558 of the housing (e.g., first housing portion 106) of the electronics assembly (211, 311), where the electronic assembly is connected to and housed within or outside a transmission housing 511 or gearbox housing and where a recess (506, 508) in the end of the electronics assembly and a portion of the transmission housing 511 collectively form a primary overflow vessel (513, 464). As illustrated in FIG. 17, the second housing portion 102 is removed or unfastened from the first housing portion 106. Further, the first housing portion 106 illustrates one or more electrical openings 516 in a wall of the first housing portion 106, where the electrical openings support the mounting of connectors for alternating current (AC) terminals (e.g., AC output terminals), direct current (DC) terminals (e.g., DC input terminals) of the electronic assembly (211, 311), which may comprise an inverter or a DC-to-DC converter.

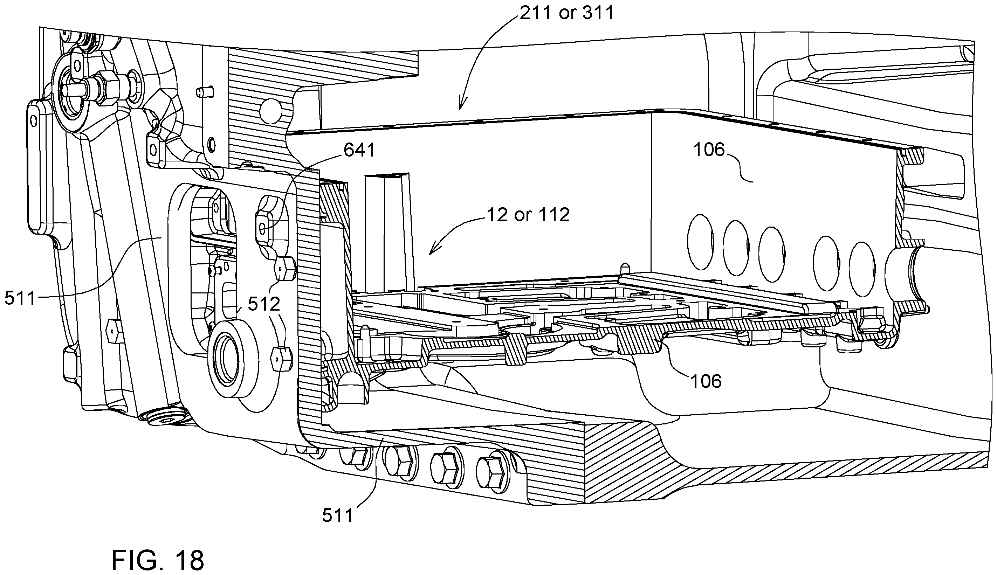

FIG. 18 shows one embodiment of a cross-sectional, perspective view of the housing (e.g., first housing portion 106) of the electronic assembly (211, 311) with the circuit board (44, 144), electronic components (46, 146), and other components removed to reveal the interior 558 of the first housing portion 106 of the electronics assembly, where the electronic assembly (211, 311) is connected to and housed within or outside a transmission housing 511 or gearbox housing and where one or more recesses (506, 508) in the end of the electronics assembly (211, 311) and a portion of the transmission housing 511 collectively form a primary overflow vessel. The first housing portion 106 has a mating flange for the gasket (20, 120), or outer lips (16, 116, 216, 316), to seal the coolant cavity region (18, 118) with respect to the electronic cavity region (12, 112), where the coolant cavity region (18, 118) contains the coolant in an isolated manner from the electronic components (46, 146) and circuit board (44, 144) within the electronic cavity region (12, 112).

In FIG. 18, the electronic assembly (211, 311) illustrates a set of removable terminating plugs 512 (e.g., inspection plugs or service plugs), where each removable terminating plug is removably engaged within a threaded bore of the transmission or gearbox housing 511, which can be used by a technician, operator, or another person to send an optical inspection camera into the primary overflow vessel that is defined by the recess (506, 508) in the housing of the electronic assembly (211, 311) together with a wall 556 (e.g., outer wall) of the transmission housing 511.

In an alternate embodiment, the removable terminating plugs 512 may be removed from the threaded bore of the terminating plugs 512 may be replaced by an inspection window device 481 (in FIG. 21) that is screwed into the open threaded bores left by removal of the terminating plugs 512.

FIG. 19 is a block diagram of an alert system for alerting an operator or user of a vehicle with respect to a possible leak or breach of the gasket (20, 120) of the electronic assembly (211, 311).

In accordance with the illustrative embodiment of FIG. 19, an electronic data processing system 450 comprises an electronic data processor 451, a data storage device 452, and one or more data ports 456 that are coupled to a data bus 454. The electronic data processor 451, the data storage device 452 and one or more data ports 456 may communicate with each other via the data bus 454. The data storage device 452 is configured to store software, such as data, libraries, and software instructions in one or more modules that can be executed by the electronic data processor 451.

The electronic data processor 451 comprises a microcontroller, a microprocessor, a system on a chip (SOC), a programmable logic array, a field programmable gate array (FPGA), a logic device, an arithmetic logic unit, a digital signal processor, an application specific integrated circuit (ASIC) or another device for processing or manipulating data.

The data storage device 452 comprises electronic memory, nonvolatile random- access memory, magnetic storage device, an optical storage device, or another device for storing, retrieving and managing data, files, data structures or data records. The data storage device 452 may store a coolant level alert module 453 that comprises software instructions that are executable by the electronic data processor 451. For example, the coolant level alert module 453 is configured to generate an alert, such as an audible alert, a visual alert, an icon alert, an active light emitting diode, an active lamp, or buzzer, on the electronic display 45 or on the alter device 457 for a coolant leak or other leakage of the gasket (20, 120) based upon sensor data provided from the first sensor 465, the second sensor 469, or both that indicates the presence of coolant or other fluid in the normally empty primary overflow vessel (464, 513), in the normally empty secondary overflow vessel 469, or both.

The data ports 456 may comprise an input/output port, a data transceiver, a wireline transceiver, a wireless transceiver, buffer memory. A user interface, such as an electronic display 458, may be coupled to a respective data port 456, where the user interface may comprise an electronic display 458 (e.g., touchscreen electronic display), a keypad, a keyboard, an electronic pointing device (e.g., electronic mouse), or one or more switches.

One or more fluid level sensors (465, 469), such as coolant level sensors, may be configured to communicate with one or more respective data ports 456 via a sensor interface 459 and a vehicle data bus 455 or other data communications line or data communications channel, or transmission line. In one embodiment, the first sensor 465 comprises a first coolant level sensor that is associated with, mounted in or mounted on a primary overflow vessel (464, 513).

An alert device 457 is configured to display a visual alert or audible alert if the first sensor 465, alone or together with the sensor interface 459, detects the presence or level of coolant (or fluid) in a primary overflow vessel and generates sensor data or a sensor signal that is provided via the transmission line 445 to the alert device 457. Similarly, an alert device 457 or electronic display 458 is configured to display a visual alert or audible alert if the first sensor 465, alone or together with the sensor interface 459, detects the presence of coolant in a secondary overflow vessel and generates sensor data or a sensor signal that is provided via the vehicle data bus 455 (e.g., and optionally transmission line 449) to the electronic display 458 and/or the transmission line 447 to the alert device 457.

In an alternate embodiment, a pressure relief valve 467 may replace or be engaged with a threaded bore or opening in the primary overflow vessel (464, 513). Further, if a pressure of fluid or coolant within the primary overflow vessel meets or exceeds a threshold level, the normally closed pressure relief valve 467 will open to allow fluid or coolant to flow between the input port and output port of the pressure relief valve 467 into an optional secondary overflow vessel 467. The secondary overflow vessel 468 is in fluidic communication within an output port of the pressure relief valve 467.

For example, if the gasket (20, 120) or the outer lips (16, 116, 216, 316) of the gasket leak, leakage, such as coolant, oil, lubricant or other fluid, may be directed along the coolant flow path 114 or from the exit aperture (40, 140) to the primary overflow vessel (464, 513) until the pressure of the leakage within the primary overflow vessel (464, 513) meets or exceeds a pressure threshold. Even if the pressure threshold of the leakage within the primary overflow vessel (464, 513) is not met or exceeded and the pressure relief valve 467 is closed (e.g., normally closed), the first sensor 465 may indicate that leakage is present within the primary overflow vessel (464, 513) or that the leakage (e.g., coolant) meets or exceeds an alert level threshold to provide an alert signal to an operator, via the electronic display 458 or via the optional alert device 457.

An optional second sensor 469 may comprise a second coolant level sensor that is associated with, mounted in, or mounted on a secondary overflow vessel 468 (e.g., where the second sensor 469 is configured to operate after or if the pressure relief valve 467 is opened). The second sensor is configured to detect the presence or level of coolant (or other fluid) in the second overflow vessel 468. The optional nature of the secondary overflow vessel 468 and the second sensor 469 is indicated by the dashed lines in FIG. 19. In some embodiments, the primary overflow vessel 464 and the second overflow vessel 468 are hydraulically coupled to each other via the pressure relief valve 467 and intermediate tubing 466. In certain embodiments, the secondary overflow vessel 468 comprises a plastic or polymeric tank or container for holding a coolant, oil, lubricant, fluid or liquid, where the secondary overflow vessel 468 may have one or more separate containers.

An alert device 457 is configured to display a visual alert or audible alert if the second sensor 469, alone or together with the sensor interface 459, detects the presence (or level) of coolant (or fluid) in a secondary overflow vessel and generates sensor data or a sensor signal that is provided via the transmission line 445 to the alert device 457. Similarly, an alert device 457 or electronic display 458 is configured to display a visual alert or audible alert if the second sensor 469, alone or together with the sensor interface 459, detects the presence of coolant in a secondary overflow vessel and generates sensor data or a sensor signal that is provided via the vehicle data bus 455 (e.g., and optionally transmission line 449) to the electronic display 458 and/or the transmission line 447 to the alert device 457.

The first coolant sensor 465 may be implemented, conducted, or replaced in accordance with various examples, which may be applied separately or cumulatively.

In a first example, the first sensor 465 comprises a coolant level sensor (or a coolant presence detector) that changes an electrical parameter based on the level of the coolant or fluid within the primary overflow vessel (464, 513) (or the presence of coolant or fluid with the primary overflow vessel), where the electrical parameter comprises resistance, capacitance or inductance. For example, first sensor 465 comprises electrical (coolant/fluid) level sensor that senses coolant level (e.g., in the primary overflow vessel, 464, 513) or fluid level based on change in resistance, capacitance, or inductance; where the first sensor 465 can be rotated into the threaded bore or port after the removable plug 512 is removed from the threaded bore. Further, the first sensor 465 may comprises a (coolant/fluid) presence detector that changes an electrical parameter based on the presence of coolant or fluid with the primary overflow vessel (454, 513) versus no coolant or air in the primary overflow vessel, where the electrical parameter comprises resistance, capacitance or inductance, and where the presence of coolant may be detected if the change in the electrical parameter exceeds a threshold of the electrical parameter.

In a second example, the first sensor 465 is replaced by single port or dual port, sight gauge device (480, 481) that is connected to the threaded bores (after removal of the removable plugs 512) with access (e.g., hydraulic access or fluidic communication) to the primary overflow vessel (464, 513) that allows an inspector, technician, operator, or other person to inspect visually whether fluid or coolant is present or not within the sight gauge (480, 481) that includes a plastic sight gauge, such as a transparent or clear plastic (e.g., nylon or acrylic) window, bubble, dome, or tube.

In a third example, the first sensor 465 comprises a float-level sensor that changes its mechanical position (or mechanical angle) based on a level (or presence) of coolant or fluid in the primary overflow vessel (513, 464) . For example, the float level sensor comprises a rotatable potentiometer float level that is rotated (e.g., angularly displaced) by a rotatable arm responsive to a change in the coolant or fluid level in the primary overflow vessel (464, 513). Alternately, the float level sensor comprises a magnetic float sensor with a magnet secured to or embedded in a slidable member or a rotatable arm responsive to change in the coolant or fluid level, where a magnetic field sensor detects the change in rotational position or change in position of the magnet responsive to the change in coolant or fluid level in the primary overflow vessel (513, 464).

In a fourth example, the first sensor 465 comprises an ultrasonic sensor that comprises a transmitter and receiver that measures the time-of-flight of one or more ultrasonic pulses or ultrasonic signals that are transmitted by the transmitter and received by the receiver (e.g., as an echo or reflection) to estimate the level of fluid or coolant in the primary overflow vessel (464, 513). For example, the time of flight equals an coefficient multiplied by the fluid level/medium speed of sound, where the time of flight, or its coefficient, varies when air is the medium versus coolant. An ultrasonic sensor is configured to detect a coolant level, fluid level, presence of coolant or fluid level in the second overflow vessel.

The optional second sensor 469 may be implemented, conducted, or replaced in accordance with various examples, which may be applied separately or cumulatively.

In a first example, the second sensor 469 comprises a coolant level sensor that changes an electrical parameter based on the level of the coolant or fluid within the secondary overflow vessel 468, where the electrical parameter comprises resistance, capacitance or inductance. For example, second sensor 469 comprises electrical coolant level sensor that senses coolant level (e.g., in the secondary overflow vessel 468) based on change in resistance, capacitance, or inductance, and that can be threaded into the threaded bore or port after the removable plug 512 is removed from the threaded bore.

In a second example, the second sensor 469 is replaced by single port or dual port, sight gauge device (480, 481) that is connected to the threaded bores (after removal of the removable plugs 512) with access (e.g., hydraulic access or fluidic communication) to the secondary overflow vessel (468) that allows an inspector, technician, operator, or other person to inspect visually whether fluid or coolant is present or not within the sight gauge (480, 481) that includes a plastic sight gauge, such as a transparent or clear plastic (e.g., nylon or acrylic) window, bubble, dome, or tube.

In a third example, the second sensor 469 comprises a float-level sensor that changes its mechanical position (or mechanical angle) based on a level (or presence) of coolant or fluid in the secondary overflow vessel 469. For example, the float level sensor comprises a rotatable potentiometer float level that is rotated (e.g., angularly displaced) by a rotatable arm responsive to a change in the coolant or fluid level in the secondary overflow vessel 468. Alternately, the float level sensor comprises a magnetic float sensor with a magnet secured to or embedded in a slidable member or a rotatable arm responsive to change in the coolant or fluid level, where a magnetic field sensor detects the change in rotational position or change in position of the magnet responsive to the change in coolant or fluid level in the secondary overflow vessel 468.

In a fourth example, the second sensor 469 comprises an ultrasonic sensor that comprises a transmitter and receiver that measures the time-of-flight of one or more ultrasonic pulses or ultrasonic signals that are transmitted by the transmitter and received by the receiver (e.g., as an echo or reflection) to estimate the level of fluid or coolant in the secondary overflow vessel 468. For example, the time of flight equals an coefficient multiplied by the fluid level/medium speed of sound, where the time of flight, or its coefficient, varies when air is the medium versus coolant. An ultrasonic sensor is configured to detect a coolant level, fluid level, presence of coolant or fluid level in the second overflow vessel.

As illustrated in FIG. 19, in some embodiments, the first sensor 465, the second sensor 469, or both are not configured to support direct communications of sensor data over the vehicle data bus 455 to the data ports 456 of the electronic data processing system 450; hence, the sensor interface 459 is configured to support, facilitate, or manage communications of sensor data between the first sensor 465 and the electronic data processing system 450, via the vehicle data bus 455 and data ports 456. Further, the sensor interface 459 is configured to support, facilitate, or manage communications of sensor data between the second sensor 469 and the electronic data processing system 450, via the vehicle data bus 455 and data ports 456.

An electronic data processing system 450, or the coolant level alert module 453, is configured to communicate over the vehicle data bus 455 to the first sensor 465 or a sensor interface 459; the electronic data processing system 450, or the coolant level alert module 453, is configured to communicate over the vehicle data bus 455 to the second sensor 469 or a sensor interface 459. The electronic display 458 is coupled to the electronic data processing system 450 (e.g., via data ports 458) to receive sensor data from the first sensor 465, a second sensor 469, or both, or indirectly via the sensor interface 459.

However, in alternate embodiments, the first sensor 465, the second sensor 469, or both are configured to support direct communications: (a) of sensor data over the vehicle data bus 455 to the data ports 456 of the electronic data processing system 450, or (b) of sensor signals (e.g., analog or digital) over transmission line 445 to the alert device 457.

In one embodiment, the sensor interface 459 may comprise a logic circuit 460 (e.g., comparator with a reference signal input and sensor signal input) that is coupled to the transceiver 463 for communicating over the vehicle data bus 455 or over a communications line on the vehicle, such as Ethernet, controller area network (CAN), or twisted pair. In some embodiments, the sensor interface 459 may further comprise an optional analog-to-digital converter 461, buffer memory 462, or both. For example, if the sensor (465, 469) comprises an analog sensor, the sensor interface 459 may comprise an analog-to-digital (A/D) converter, which is, in turn, coupled directly or indirectly to a corresponding data port 456. The sensor (465, 469), alone or together with the sensor interface 459, is configured to output a logic level signal or data message (e.g., CAN data message or data packet) to activate an alert (e.g., visual alert or audible alert) on the electronic display 456 or an alert device 457, such as warning indicator light on the control panel. The buffer memory 462 may store and hold or accumulate one or more logic level signals, or data messages until a communications channel is available or established over the vehicle data bus 455 or over a separate wireline, wireless or transmission line.

FIG. 20 is a perspective view of one embodiment of a visual inspection device 480 end cap or terminating cap with visual inspection window. As illustrated in FIG. 20, the visual inspection device 480 comprises a body with hexagonal perimeter 471 and a threaded port 472 that can engage the port in the wall of the transmission housing 511 (after the removable plug is removed). A translucent or clear plastic dome 471 is composed of nylon, acrylic or another suitable plastic or polymer that communicates fluid or coolant along a path 473 via a hollow passageway in the body and threaded port 472 to enable an inspector, technician or other person to view or observe visually coolant in the primary overflow vessel (464, 513) via the dome 470.

FIG. 21 is a cross-sectional view of one embodiment of a fluid level gauge with a cylindrical viewing member and two fluidic connection ports. As illustrated in FIG. 21, the visual inspection device 481 comprises a clear or translucent visual inspection tube 475 that is terminated at each end portion 477 by a threaded port 472 that is orthogonal to the longitudinal axis of the inspection tube 475. Each threaded port 472 can engage a respective port in the wall of the transmission housing 511 (after the removable plug is removed). Via the fastener head 476 and the bolt shaft 479 shown in phantom, the threaded ports 472 can rotate to engage the respective threaded bores in the wall of the transmission housing 511, where the external threads of the bolt shaft 479 can engage internal threads (not shown) of the threaded ports 472 (e.g., annular threaded ports). A seal 485, such as an elastomeric O-ring, can seal the gap between the fastener 476 and end portion 477. Meanwhile, a hollow passageway 482 (e.g., annular passageway that connects to a cylindrical passageway at a substantially perpendicular angle) allows the coolant to flow into the translucent visual inspection tube 475. The clear or translucent visual inspection tube 475 is composed of nylon, acrylic or another suitable plastic or polymer that communicates fluid or coolant along a path 473 via a hollow passageway 482 in the ends and threaded port 472 to enable an inspector, technician or other person to view or observe visually coolant level 474 in the primary overflow vessel (464,513).

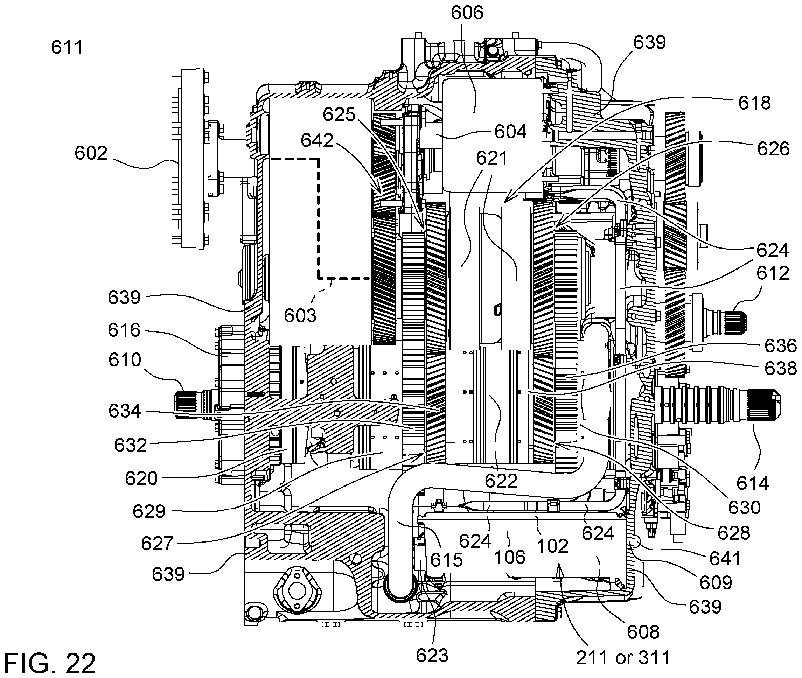

FIG. 22 is a cross-sectional view of one embodiment of a transmission system 611 that comprises a gearbox system 618, an electric machine 606, and an electronic assembly 608 with a gasket (20, 120), which has a channel (17, 117, 217) for venting or directing fluid to an overflow vessel, where the overflow vessel may comprise a primary overflow vessel (464, 513), a secondary overflow vessel 468, or both. Within the transmission system 611, an electric machine 606 is rotationally coupled to the gearbox system 611 via one or more intermediary gears. Further, an electronic assembly 608 is configured to provide one or more control signals via a plurality of conductors to the electric machine 606 to control the torque, speed or both of the rotor of the electric machine 606, via its alternating current terminals. The electronic assembly 608 has a housing with a first housing portion 106 and second housing portion 102 that are sealed by a gasket (20, 120) with a channel (17, 117, 217) for venting or directing leaking coolant or fluid to an overflow vessel to protect an electronics cavity region (12, 112) from the leaking coolant or fluid wherein the fluid comprises the coolant, transmission fluid or both coolant and transmission fluid.

The transmission system 611 comprises a gearbox system 618 within the transmission housing. where the gearbox system 611 comprises one or more gear assemblies (625, 626, 628, 628, 603). An electric machine 606 rotationally coupled to the gearbox system 618 via one or more (intermediate) gear assemblies of the gearbox system 618. The electronics assembly (211, 311), such as an inverter or machine controller, is configured to provide one or more control signals via a plurality of conductors 624 to the electric machine 606 to control the torque or speed of the rotor of the electric machine 606, via its alternating current terminals 623.
The electronics assembly (e.g., 211, 311 inverter) has a housing with a first housing portion 106 and second housing portion 102 that are sealed by a gasket (20, 120) with a channel (17, 117, 217) for venting or directing leaking coolant or transmission fluid to an overflow vessel (464, 468, 513). The transmission system 611 further comprises a sensor (e.g., first sensor or second sensor) for detecting the presence of coolant in the overflow vessel (464, 468, 513). An alert device 457 is configured to display a visual alert or audible alert if the first sensor detects the presence of coolant or fluid in the overflow vessel (464, 468, 513), wherein the fluid comprises the coolant, transmission fluid or both coolant and transmission fluid.

In one embodiment, the gasket (20, 120) is configured to form a liquid-isolating, redundantly sealed boundary between an electronics cavity (12, 112) and the transmission fluid or other lubricant within the interior of the transmission housing 639, where the channel (17, 117) of the gasket can direct leaking fluid to one or more overflow vessels ( 464, 468, 513). In another embodiment, the gasket (20, 120) is configured to form a liquid-isolating, redundantly sealed boundary between an electronics cavity (12, 112) and a coolant fluid within one or more coolant cavities (18, 118) of the electronics assembly or inverter, where the channel (17, 117) of the gasket can direct leaking fluid to one or more overflow vessels ( 464, 468, 513).

In one embodiment, an adjustable pressure regulator 133 comprises an adjustable regulator valve and a coolant pressure sensor coupled in series with the tubing 109 or coolant lines of the coolant system of FIG. 1; where the adjustable pressure regulator 133 is configured to regulate, reduce or limit an observed pressure of the coolant circulating within the one or more coolant cavities (18, 118) of the electronic assembly (211, 311) upon detection of a leak in the gasket (20, 120) or presence of coolant in the overflow vessel (464, 468, 513), wherein the observed pressure is detected by a coolant pressure sensor or adjustable pressure regulator 133.

The outer housing 639 of the transmission system 611 is cut away to reveal at least a portion of the gearbox system 618. The gearbox system 618 has an input shaft 602 that can be coupled to a flywheel (alone or in conjunction with a torque converter) of an internal combustion engine via a set of fasteners (e.g., bolts). The input shaft 602 transmits rotational energy to an intermediate gear assembly 603 (e.g., with selectable gear ratios via an input clutch assembly). The input shaft 602 may be associated with a parking brake 616 to prevent the vehicle wheels from rotating when the vehicle is at rest, inactive or parked.

The gearbox system 618 comprises a first gear assembly 625, a second gear assembly 626, a third gear assembly 627, a fourth gear assembly 628 and an intermediate gear assembly 603. Each gear assembly (625, 626, 628, 628, 603) comprises a set of one or more gears that can transmit rotational energy between two or more rotatable shafts of the transmission system 611 in selectable modes of operation. For example, in one illustrative configuration, the first gear assembly 625 comprises a low output cluster gear set; the second gear assembly 626 comprises a high output cluster gearset; the third gear assembly 627 comprises a mode (2) gear set 632 and a mode (4) gear set 634; the fourth gear assembly 628 comprises a mode (3) gear set 636 and mode (5) gear set 638, which individually and collectively support different modes of operation of the transmission. Further, in some configurations, the gear assembly (625, 626, 628, 628, 603) may be associated with a variator (e.g., hydraulic/hydrostatic variator, electrical motor driven variator, or mechanical pulleys coupled to a belt) to vary continuously a gear ratio between two shafts, rotors or gears of the transmission.

A transmission controller (e.g., electronic transmission controller) or another electronic data processing system 450 may generate a control signal (e.g., via data ports, the vehicle data bus, or conductors) that is configured to engage or disengage, or activate or deactivate one or more clutch assemblies (629, 630, to realize one the modes of operation. For example, one or more clutches (e.g., electrohydraulic clutches or electromagnetic clutches) determine the mode of operation in which rotational energy is transferred from a rotational energy source via one or more gear assemblies (625, 626, 628, 628) to one or more output shafts (610. 612, 614), where the rotational energy source comprises the internal combustion engine at the input shaft 602, the electric machine at the rotor 604 (e.g., rotor shaft), or both. As illustrated in FIG. 22 the clutch assemblies comprise a first clutch assembly 629 (e.g., mode 2 clutch assembly), a second clutch assembly 630 (e.g., mode 3 clutch assembly), a third clutch assembly 622 (e.g., mode 4/5 clutch assembly), and a forward clutch assembly 620. However, in alternate embodiments, additional clutch assemblies or selectable gear actuators (e.g., electrohydraulic, electromagnetic or linear actuators) may be used, alone or together with other clutch assemblies.

The mode of operation of the transmission system 611 can be characterized by any of the following (e.g., between any input shaft 602 and output shaft (610, 612, 614)): a gear ratio, one or more power paths via an active set of one or more engaged and rotatable gears of the gearbox system, a series power path through a clutch-selectable active gears (e.g., active gear set) of the transmission, a parallel power path through clutch-selectable active gears of the transmission, a power path via one or more selectable (e.g., clutch selectable) planetary gears, such as dual planetary gearset 621, to change the speed of rotation between the input shaft and the output shaft and/or to adjust torque, a motoring mode of the electric machine 606, and a power generating mode of the electric machine 606.

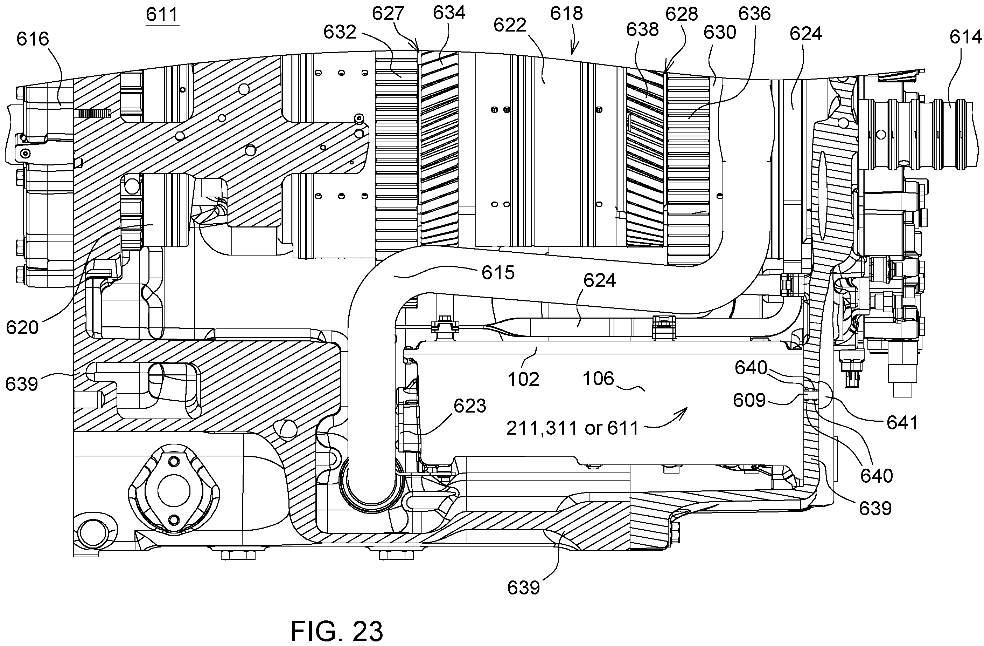

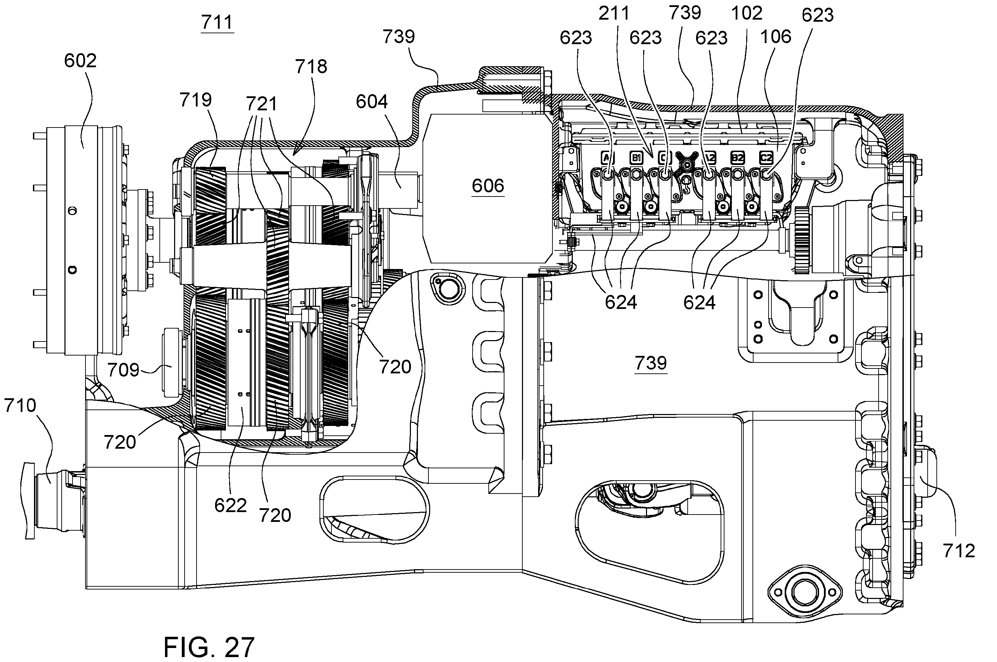

Although in FIG. 22 and FIG 23 the electric machine 606 is positioned within the transmission housing 639 at or near the bottom (e.g., sump region in which transmission fluid or lubricant collects or pools) of the transmission housing 639, in alternate embodiments, the electric machine 606 can be positioned within the transmission housing 639 at a top, middle or bottom of the transmission housing or outside the transmission housing, as illustrated in FIG. 27. The electric machine 606 has a rotatable rotor shaft or rotor 604. In the motoring mode or the power generating mode, the rotor 604 can be coupled to interface gears or intermediary gears, which in turn can engage other gears in the gearbox system 618, such as the first gear assembly. During operation in a motoring mode via the inverter (211, 311), the electrical machine converts electrical energy from an energy storage device (e.g., battery, ultracapacitor, supercapacitor or battery bank) into rotational energy by the electric machine 606, which can replace or supplement any rotational energy at the input shaft 602 from the internal combustion engine through proper mode selection of the transmission.

During operation in a generating mode via the proper mode selection of the transmission, the electric machine 606 converts rotational energy from the output shafts (610, 612, 614), such as one or more output shafts that rotate the wheels or axles of a vehicle in which the transmission system 611 is mounted, into electrical energy to be rectified and stored by the inverter in an electrical energy storage device, such as a battery, a capacitor bank, or both. For off-road work vehicles or tractors, the output shafts may further comprise a power take-off shaft 612.

In an alternate embodiment, the transmission controller may generate a control signal that is configured to engage or disengage, or activate or deactivate a clutch assembly (e.g., intermediate clutch) assembly to realize isolation of the electric machine 606 from the rest of the gearbox, such as where the electronic assembly (21, 311, e.g., inverter) is disabled or switched off.

The electronics assembly (211, 311) or inverter has alternating current (AC) electrical terminals 623 that are connected to cables, bus bars or other conductors 624 that are routed to respective alternating current terminals (e.g., AC phase terminals) of the electric machine 606 to provide AC control signals (e.g., pulse width modulated signals) to control the rotor torque, rotor speed, or other electric machine parameters (e.g., in the motoring mode) of the electric machine 606. Although the electronic assembly may be located within the transmission housing or outside the transmission housing, in one embodiment the electronic assembly (211, 311) is located within a bottom third of the transmission housing. Further, in some embodiments, the electronic assembly is submerged within transmission fluid or lubricant in a sump region of the transmission housing of the transmission system.

In the power generating mode of the electric machine 606, the electronics assembly (211, 311) or inverter (e.g., bidirectional inverter) can rectify the alternating current signals that the electric machine 606 applies to the alternating current terminals of the electronics assembly (211, 311); hence, the direct current terminals of the electronics assembly (211, 311) may provide electrical energy to an energy storage device (e.g., battery, not shown) for storage. As illustrated in FIG. 22 and FIG. 23, the cables, bus bars or conductors 624 are shown as bus bar conductors with generally rectangular cross section, although in practice braided conductors, stranded conductors, wires, cables, or other conductors with other cross sections may be used. Further, the cables, bus bars or conductors 624 may have a dielectric coating, dielectric insulation sheath, a dielectric layer, dielectric barrier or armor sheathing of plastic, polymer or elastomer to provide physical and electrical isolation from the hydraulic fluid, transmission fluid, oil, grease or other lubricant within the interior of the transmission housing 639 and its gearbox system 618 (e.g., its lubricant pan/reservoir) that is used to lubricate the gears, shafts, and other mechanical parts of the gearbox and transmission (e.g., to protect the metal conductors from contaminants, moisture, corrosion, acidity, ions; salts, such as sodium, potassium, calcium magnesium, phosphate salts; or oxidation/aging of the lubricant).

An electrical pump may be located outside of the transmission system 611 or within the transmission at the bottom of the transmission or pan of the transmission to convey or circulate hydraulic fluid, transmission fluid, oil, grease or other lubricant upwards through the hydraulic fluid line (e.g., 615), which has an output port near or at a peak height of the hydraulic fluid line to support gravity-fed lubrication of the gearbox system, alone or together with lubrication afforded by the motion of the gears and shafts, which may have optional integral pump structures for circulating the lubricant.

In an alternate embodiment, a resistive sensor (e.g., resistance temperature sensor) is configured to detect the resistance of the hydraulic fluid, transmission fluid, oil or grease within the interior of the transmission housing 639. The resistive sensor can be mounted within a threaded bore within the wall of the transmission housing 639 at or below the normal level of transmission fluid, hydraulic fluid, oil or lubricant within the transmission system 611 or resistive sensor mounted in a threaded bore within the bottom third of the gearbox system 618. The resistive sensor may be coupled to a data port 456 of the electronic data processing system 450, or the vehicle data bus 455, to provide an operator or user with one or more of the following if an observed resistance level of the transmission fluid, hydraulic fluid, oil or lubricant is less than a threshold resistance level (e.g., excess temperature of transmission fluid): an alert or warning (e.g., by an alert device 457 or electronic display 458), a transmission disable signal of the transmission system 611 and/or inverter disable signal of the electronic assembly (211, 311).

As illustrated in FIG. 22, the transmission system 611 has a coolant port for circulating coolant to and from the electric machine 606 via one or more conduit or coolant lines that are coupled to a heat exchanger. Typically, the transmission fluid, hydraulic fluid, oil, or other lubricant is directed via fluid transmission lines to a secondary heat exchanger and secondary pump that circulate the lubricant to reduce the heat in the transmission assembly.

In an alternate embodiment, a conduit or coolant lines may be routed through an optional heat sink within the transmission housing of the transmission system 611 to conduct heat or provide a thermal pathway to the heat exchanger, where the transmission fluid, hydraulic fluid, oil or lubricant are circulated through the optional heat exchanger to remove thermal energy from the gearbox system 618, or from the transmission system 611 and electric machine 606 (e.g., which is or can be configured with fluid coolant ports and passageways), collectively.

FIG. 23 is an enlarged lower region of the transmission system of FIG. 22. Like reference numbers in FIG. 22 and FIG. 23 indicate like elements or features. FIG. 23 illustrates the vent 609 comprises a vent tube (e.g., vent channel) and vent cover 641 that provides an air path between the interior (e.g., electronics cavity region 12, 112) of the electronics assembly (211 or 311, e.g., inverter) and the ambient air outside of the transmission housing 639 or at the exterior of the transmission system 611. The vent 609 or vent tube has seals 640, such as dual elastomeric O-rings, at the housing portion (106) or housing wall of the electronics assembly (211 or 311) and at the transmission housing 639: (a) to prevent the ingress of coolant, transmission fluid, hydraulic fluid, oil or a lubricant into the interior or electronics cavity (12, 112) of the electronics assembly (211, 311) through any (wall) opening that the vent tube passes through, and/or (b) to prevent the egress of transmission fluid, hydraulic fluid, oil or lubricant outside the transmission housing 639 through any (wall) opening that the vent tube passes through. The vent 609 has vent cover 641 that may comprise a lid. Further, the lid may comprise a valve (e.g., unidirectional valve or bidirectional valve) or an air filter (e.g., membrane or fiberglass) to prevent the ingress of moisture or contaminants into the vent or vent tube, while allowing the flow of sufficient air volume per unit time to reduce promptly any pressure differential between the ambident exterior air and the interior air of the electronics cavity (12, 112), which tends to address or reduce the any pressure differential on the gasket (20, 120) between the fluid the gasket (20, 120) confines within one or more coolant cavities (18, 118) and the one or more electronics cavities (12, 112).

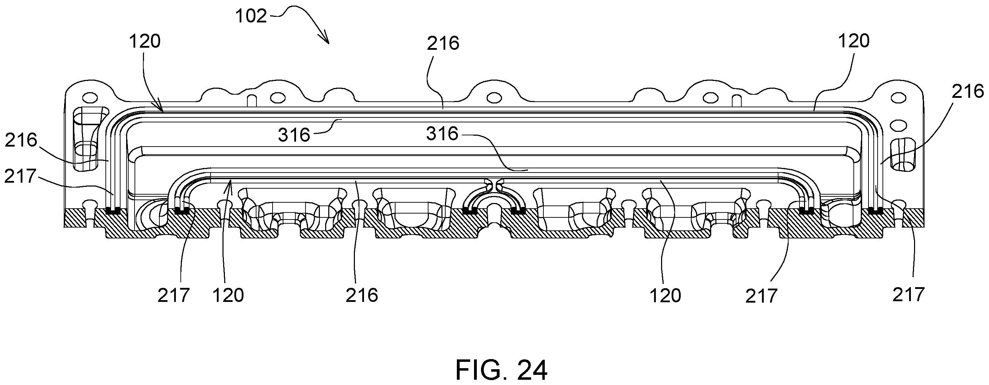

FIG. 24 is a cross-section perspective view of an alternate embodiment of a housing portion of the electronic assembly with a generally U-shaped gasket or rectangular gasket with a central channel for directing overflow or leaking fluid (e.g., coolant) to an overflow vessel. The generally U-shaped gasket 120 has a central channel 217 and outer lips, such as first lip 216 and a second lip 316.

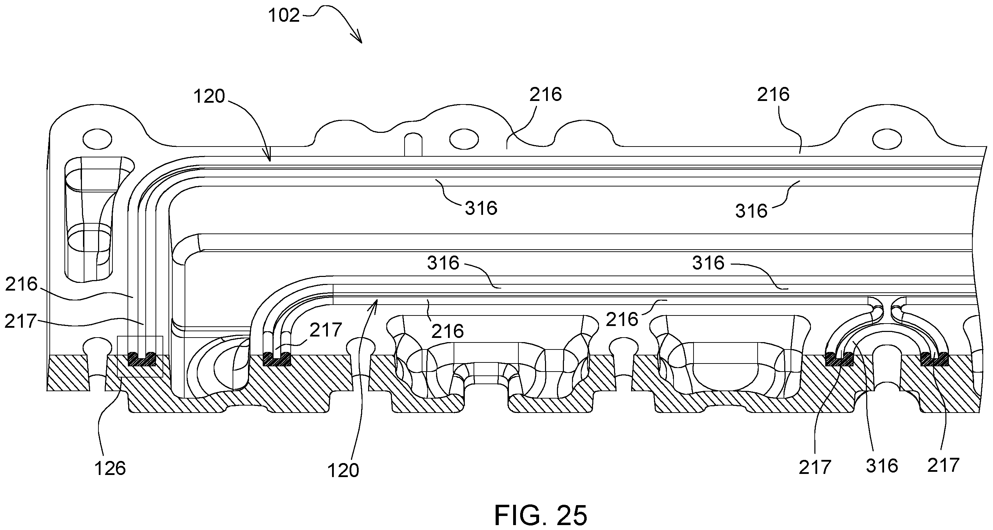

FIG. 25 shows an enlarged region of the housing portion of the electronic assembly of FIG. 24. The generally U-shaped gasket 120 has a central channel 217 and outer lips, such as first lip 216 and a second lip 316. Like reference numbers in FIG. 24 and FIG. 25 indicate like features or elements.

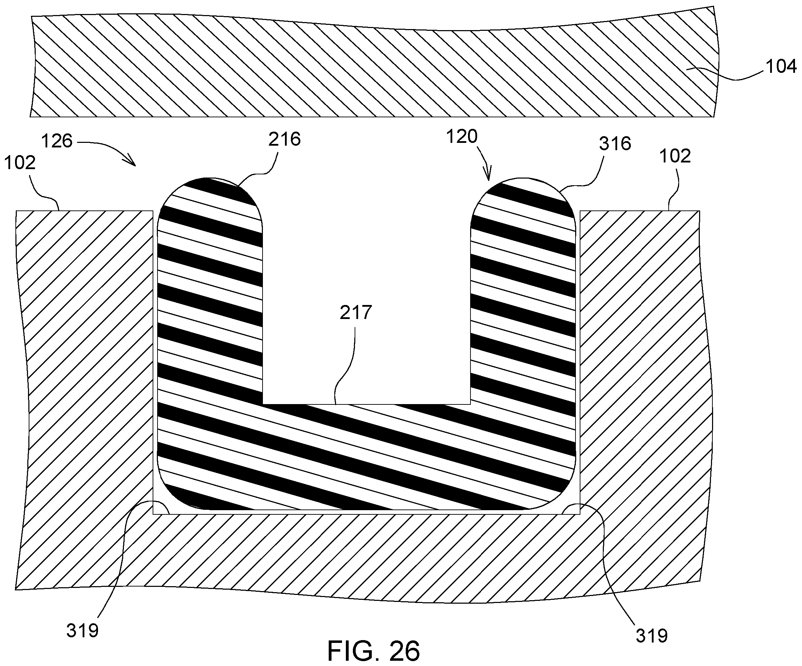

FIG. 26 shows an enlarged cross-section the housing portions of an electronic assembly with an illustrative gasket, consistent with FIG. 24. Similar to FIG. 25, FIG. 26 has a generally U-shaped gasket 120 has a central channel 217 and outer lips, such as first lip 216 and a second lip 316. The U shaped gasket 120 is seated in a groove, channel or recess 319. Further, in some configurations, the U-shaped gasket 120 may have a press-fit, a compression fit, or other mechanical fit within the groove, channel or recess 319 to retain the U-shaped gasket 120 within the channel while the first housing portion 106 and the second housing portion 102 are mated, joined or connected via one or more fasteners to provide a liquid tight, fluid tight or hermetic seal of the coolant within the coolant cavity region (18, 118) of the electronic assembly (211, 311).

FIG. 27 is a cross-sectional view of another embodiment of a transmission system 711 that comprises a gearbox, an electric machine 606, and an electronic assembly with a gasket for venting or directing fluid to an overflow vessel. Like reference numbers in FIG. 27 and any other drawing indicate like elements or features.

The mode of operation of the transmission system 711 can be characterized by any of the following (e.g., between any input shaft 602 and output shaft (709, 710, 712): a gear ratio, one or more power paths via an active set of one or more engaged and rotatable gears of the gearbox system, a series power path through a clutch-selectable active gears (e.g., active gear set) of the transmission, a parallel power path through clutch-selectable active gears of the transmission, a power path via one or more selectable (e.g., clutch selectable) planetary gears, such as dual planetary gearset, to change the speed of rotation between the input shaft 602 and the output shaft (709, 710, 712) and/or to adjust torque, a motoring mode of the electric machine 606, and a power generating mode of the electric machine 606.

In FIG. 27, the electric machine 606 is positioned within the transmission housing 739 at or near the top or top third of the transmission housing 739, or outside the transmission housing 739. The electric machine 606 has a rotatable rotor shaft or rotor 604. In the motoring mode or the power generating mode, the rotor 604 can be coupled to interface gears or intermediary gears 719, which, in turn, can engage other gears (720, 721) in the gearbox system 718. During operation in a motoring mode via the inverter (211, 311), the electrical machine 606 converts electrical energy from an energy storage device (e.g., battery, ultracapacitor, supercapacitor or battery bank) into rotational energy by the electric machine 606, which can replace or supplement any rotational energy at the input shaft 602 from the internal combustion engine through proper mode selection of the transmission system 711.

During operation in a generating mode via the proper mode selection of the transmission system 711, the electric machine 606 converts rotational energy from the output shafts (709, 710, 712), such as one or more output shafts that rotate the wheels or axles of a vehicle in which the transmission system 711 is mounted, into electrical energy to be rectified and stored by the electronic assembly (e.g., 211, 311, inverter) in an electrical energy storage device, such as a battery, a capacitor bank, or both. For off-road work vehicles or tractors, the output shafts (709, 710, 712) may further comprise a power take-off shaft, a drive axle shaft, or otherwise.

In an alternate embodiment, the transmission controller may generate a control signal that is configured to engage or disengage, or activate or deactivate a clutch assembly (e.g., intermediate clutch) assembly to realize isolation of the electric machine 606 from the rest of the gearbox 718, such as where the electric machine 606, or the electronic assembly (e.g., 211, 311, inverter) is disabled or switched off.

The electronics assembly (211, 311) or inverter has alternating current (AC) electrical terminals 623 that are connected to cables, bus bars or other conductors 624 that are routed to respective alternating current terminals (e.g., AC phase terminals) of the electric machine 606 to provide AC control signals (e.g., pulse width modulated signals) to control the rotor torque, rotor speed, or other electric machine parameters (e.g., in the motoring mode) of the electric machine 606. The conductors comprise any of the following: bus bar conductors, cables with a dielectric insulation sheath or dielectric insulation, or wires with a dielectric insulation sheath or dielectric insulation.

In the power generating mode of the electric machine 606, the electronics assembly (211, 311) or inverter (e.g., bidirectional inverter) can rectify the alternating current signals that the electric machine 606 applies to the alternating current terminals of the electronics assembly (211, 311); hence, the direct current terminals of the electronics assembly (211, 311) may provide electrical energy to an energy storage device (e.g., battery, not shown) for storage. As illustrated in FIG. 22 and FIG. 23, the cables, bus bars or conductors 624 are shown as bus bar conductors with generally rectangular cross section, although in practice braided conductors, stranded conductors, wires, cables, or other conductors with other cross sections may be used. Further, the cables, bus bars or conductors 624 may have a dielectric coating, dielectric insulation sheath, a dielectric layer, dielectric barrier or armor sheathing of plastic, polymer or elastomer to provide physical and electrical isolation from the hydraulic fluid, transmission fluid, oil, grease or other lubricant within the interior of the transmission housing 739 and its gearbox system 718 (e.g., its lubricant pan/reservoir) that is used to lubricate the gears, shafts, and other mechanical parts of the gearbox and transmission (e.g., to protect the metal conductors from contaminants, moisture, corrosion, acidity, ions; salts, such as sodium, potassium, calcium magnesium, phosphate salts; or oxidation/aging of the lubricant).

As shown in FIG. 27, the electronic assembly 211 is located at or near a top of the transmission housing 711. The first alternating current terminals 623 of the electronic assembly 211 are electrically connected or coupled to first alternating current terminals of the electric machine 606 via conductors 624 that extend laterally and vertically between the first alternating current terminals 623 and the second alternating current terminals. A machine housing of the electric machine 606 is spaced apart laterally from an electronic housing of the electronic assembly 211. In some embodiments, the electronics assembly 211 comprises an inverter or a bi-directional inverter.

Embodiments of the present disclosure may be described with reference to the following numbered clauses, with preferred features laid out in the dependent clauses:
Clause 1. An electronic assembly comprising:
   a first housing portion having an electronics cavity for housing a circuit board with a plurality of heat-generating electronic components mounted on a respective thermal plate or on a respective circuit board;
   a second housing portion having a coolant cavity or coolant channel for circulating a coolant to dissipate heat from the heat-generating electronic components; and
   a gasket for isolating or hermetically sealing the electronics cavity from the coolant circulating in the coolant cavity or coolant channel, wherein the gasket comprises seal with two outer lips and a primary channel between the outer lips for conveying coolant to an exit aperture within the primary channel if coolant penetrates one of the outer lips facing the coolant cavity to prevent the ingress of fluid into the electronics cavity;
   a primary overflow vessel that is capable of receiving coolant from the exit aperture via an overflow linkage channel;
   a first sensor for detecting the presence of coolant in the primary overflow vessel; and
   an electronic display or alert device configured to display a visual alert or audible alert if the first sensor detects the presence of coolant in a primary overflow vessel.
Clause 2. The electronic assembly according to clause 1 wherein the primary overflow vessel that is capable of receiving coolant from the exit aperture via an overflow linkage channel between the recess and the exit aperture.
Clause 3. The electronic assembly according to clause 1 wherein the primary overflow vessel is defined by a recess in an end of the first housing portion, a wall of a transmission housing, and an intermediate seal between facing or mating surfaces of first housing portion and the wall.
Clause 4. The electronic assembly according to clause 1 wherein the overflow linkage channel is disposed between the recess and the exit aperture.
Clause 5. The electronics assembly according to clause 1 wherein visual inspection device engages a threaded bore in the wall of the transmission housing to support visual inspection of fluid in the primary overflow vessel.
Clause 6. The electronics assembly according to clause 1 wherein the first sensor comprises a fluid level sensor for detecting a fluid level based on changes in a electrical parameter, where the first sensor engages a threaded bore in the wall of the transmission housing, wherein the electrical parameter comprises resistance, capacitance or inductance.
Clause 7. The electronics assembly according to clause 1 further comprising:
   a pressure relief valve that engages a threaded bore in the wall of the transmission housing, an input port of the pressure relief valve responsive to pressure within the primary overflow vessel to open the pressure relief value between the input port and the output port when the pressure exceeds a threshold pressure;
   a secondary overflow vessel being in fluidic communication with an output port of the pressure relief value;
   a second sensor for detecting the presence of coolant in the second overflow vessel; and
   an electronic display or alert device configured to display a visual alert or audible alert if the second sensor detects the presence of coolant in a secondary overflow vessel.
Clause 8. The electronics assembly according to clause 7 wherein the second sensor comprises an ultrasonic sensor for detecting a fluid level or presence of coolant in the second overflow vessel.
Clause 9. The electronics assembly according to clause 7 wherein the second sensor comprises a float level for detecting a fluid level or presence of coolant in the second overflow vessel.
Clause 10. The electronic assembly according to clause 1 further comprising:
   a vehicle data bus;
   an electronic data processing system configured to communicate over the vehicle data bus to the first sensor or a sensor interface;
   the electronic display coupled to the electronic data processing system to receive sensor data from the first sensor, a second sensor, or both.
Clause11. An electronic assembly comprising:
   a first housing portion having an electronics cavity for housing a circuit board with heat-generating electronic components mounted on a respective thermal plate or on a respective circuit board;
   a second housing portion having a coolant cavity or coolant channel for circulating a coolant to dissipate heat from the heat-generating electronic components; and
   a gasket for isolating or hermetically sealing the electronics cavity from the coolant circulating in the coolant cavity or coolant channel, wherein the gasket comprises seal with two outer lips and a primary channel between the outer lips for conveying coolant to an exit aperture within the primary channel if coolant penetrates one of the outer lips facing the coolant cavity to prevent the ingress of fluid into the electronics cavity;
   a primary overflow vessel that is capable of receiving coolant from the exit aperture via an overflow linkage channel;
   a first sensor for detecting the presence of coolant in the primary overflow vessel; and
   an alert device configured to display a visual alert or audible alert if the first sensor detects the presence of coolant in a primary overflow vessel.
Clause 12. The electronic assembly according to clause 11 further comprising:
   a transmission line coupled between the sensor interface and the alert device for providing or transmitting sensor data or sensor signals to the alert device.
Clause 13. A transmission system comprises:
   a transmission housing;
   a gearbox comprising a gear assembly within the transmission housing;
   an electric machine rotationally coupled to the gearbox via one or more intermediary gears;
   an electronic assembly for providing one or more control signals via a plurality of conductors to the electric machine to control the torque or speed of the rotor of the electric machine, via its alternating current terminals, the electronic assembly having a housing with a first housing portion and second housing portion that are sealed by a gasket with a channel for venting or directing leaking coolant or fluid to an overflow vessel to protect an electronics cavity region from the leaking coolant or fluid.
Clause 14. The transmission system according to clause 13 further comprising:
   a first sensor for detecting the presence of the coolant or the fluid in the overflow vessel; and
   an alert device configured to display a visual alert or audible alert if the first sensor detects the presence of the coolant or the fluid in the overflow vessel, wherein the fluid comprises the coolant, transmission fluid or both coolant and transmission fluid.
Clause 15. The transmission system according to clause 13 further comprising a vent that provides an air path between an interior electronics cavity of the controller and ambient air outside of the transmission housing via vent channel or tube that is sealed to prevent the ingress of transmission fluid within the transmission housing into the interior electronics cavity of the controller.
Clause 16. The transmission system according to clause 15 wherein the gasket is configured to form a liquid-isolating, redundantly sealed boundary between an electronics cavity and the transmission fluid within the interior of the transmission housing.
Clause 17. The transmission system according to clause 15 wherein the gasket is configured to form a liquid-isolating, redundantly sealed boundary between an electronics cavity and a coolant fluid within one or more coolant cavities of the inverter.
Clause 18. The transmission system according to clause 17 further comprising:
   an adjustable pressure regulator valve and a coolant pressure sensor coupled in series with the coolant lines of the coolant system; where the adjustable pressure regulator is configured to regulate, reduce or limit an observed pressure of the coolant circulating within the one or more coolant cavities of the electronic device upon detection of a leak in the gasket or presence of coolant in the overflow vessel, wherein the observed pressure is detected by a coolant pressure sensor.
Clause 19. The transmission system according to clause 13 wherein the conductors comprise any of the following: bus bar conductors, cables with a dielectric insulation sheath or dielectric insulation, or wires with a dielectric insulation sheath or dielectric insulation.
Clause 20. The transmission assembly according to clause 13 wherein the electronic assembly is located within a bottom third of the transmission housing.
Clause 21. The transmission assembly according to clause 20 wherein the electronic assembly is submerged within transmission fluid or lubricant in a sump region of the transmission system.
Clause 22. The transmission assembly according to clause 13 wherein the electronic assembly is located at or near a top of the transmission housing.
Clause 23. The transmission assembly according to clause 22 wherein first alternating current terminals of the electronic assembly are electrically connected or coupled to first alternating current terminals of the electric machine via conductors that extend laterally and vertically between the first alternating current terminals and the second alternating current terminals.
Clause 24. The transmission assembly according to clause 23 wherein a housing of the electric machine is spaced apart laterally from a housing of the electronic assembly.
Clause 25. The transmission assembly according to clause 13 wherein the electronics assembly comprises an inverter or a bi-directional inverter.
Although certain embodiments of an electronic assembly have been described in this disclosure, the scope of the present invention is defined by the following independent claims.

## Claims

1. An electronic assembly comprising:
a first housing portion having an electronics cavity for housing a circuit board with a plurality of heat-generating electronic components mounted on a respective thermal plate or on a respective circuit board;
a second housing portion having a coolant cavity or coolant channel for circulating a coolant to dissipate heat from the plurality of heat-generating electronic components; and
a gasket for isolating or hermetically sealing the electronics cavity from the coolant circulating in the coolant cavity or coolant channel, wherein the gasket comprises a seal with two outer lips and a primary channel between the outer lips for conveying coolant to an exit aperture within the primary channel if coolant penetrates one of the outer lips facing the coolant cavity to prevent the ingress of fluid into the electronics cavity;
a primary overflow vessel that is capable of receiving coolant from the exit aperture via an overflow linkage channel;
a first sensor for detecting the presence of coolant in the primary overflow vessel; and
an electronic display or alert device configured to display a visual alert or audible alert if the first sensor detects the presence of coolant in a primary overflow vessel.

2. The electronic assembly according to claim 1 wherein the primary overflow vessel is defined by a recess in an end of the first housing portion, a wall of a transmission housing, and an intermediate seal between facing or mating surfaces of first housing portion and the wall.

3. The electronic assembly according to claim 1 or 2 wherein the overflow linkage channel is disposed between the recess and the exit aperture.

4. The electronics assembly according to any preceding claim further comprising a visual inspection device that engages a threaded bore in the wall of the transmission housing to support visual inspection of fluid in the primary overflow vessel.

5. The electronics assembly according to any preceding claim wherein the first sensor comprises a fluid level sensor for detecting a fluid level based on changes in an electrical parameter, where the first sensor engages a threaded bore in the wall of the transmission housing, and wherein the electrical parameter comprises resistance, capacitance or inductance.

6. The electronics assembly according to any preceding claim further comprising:
a pressure relief valve that engages a threaded bore in the wall of the transmission housing, wherein an input port of the pressure relief valve is responsive to a pressure within the primary overflow vessel to open the pressure relief value between the input port and the output port when the pressure exceeds a threshold pressure;
a secondary overflow vessel in fluidic communication with an output port of the pressure relief value;
a second sensor for detecting the presence of coolant in the second overflow vessel; and
an electronic display or alert device configured to display a visual alert or audible alert if the second sensor detects the presence of coolant in a secondary overflow vessel.

7. The electronics assembly according to claim 6 wherein the second sensor comprises:
an ultrasonic sensor for detecting a fluid level or presence of coolant in the second overflow vessel; or
a float level for detecting a fluid level or presence of coolant in the second overflow vessel.

8. The electronic assembly according to any preceding claim further comprising:
a vehicle data bus; and
an electronic data processing system configured to communicate over the vehicle data bus to the first sensor or a sensor interface;
wherein the electronic display is coupled to the electronic data processing system to receive sensor data from the first sensor, a second sensor, or both.

9. The electronic assembly according to any preceding claim further comprising a transmission line coupled between a sensor interface and the alert device for providing or transmitting sensor data or sensor signals to the alert device.

10. A transmission system comprises:
a transmission housing;
a gearbox comprising a gear assembly within the transmission housing;
an electric machine rotationally coupled to the gearbox via one or more intermediary gears; and
an electronic assembly for providing one or more control signals via a plurality of conductors to the electric machine to control the torque or speed of the rotor of the electric machine, via its alternating current terminals, the electronic assembly having:
a housing with a first housing portion and second housing portion that are sealed by a gasket with a channel for venting or directing leaking coolant or fluid to an overflow vessel to protect an electronics cavity region from the leaking coolant or fluid;
a first sensor for detecting the presence of the coolant or the fluid in the overflow vessel; and
an alert device configured to display a visual alert or audible alert if the first sensor detects the presence of the coolant or the fluid in the overflow vessel, wherein the fluid comprises the coolant, transmission fluid or both coolant and transmission fluid.

11. The transmission system according to claim 10 further comprising a vent that provides an air path between an interior electronics cavity of the controller and ambient air outside of the transmission housing via vent channel or tube that is sealed to prevent the ingress of transmission fluid within the transmission housing into the interior electronics cavity of the controller.

12. The transmission system according to claim 11 wherein the gasket is configured to form a liquid-isolating, redundantly sealed boundary between an electronics cavity and:
the transmission fluid within the interior of the transmission housing; or
a coolant fluid within one or more coolant cavities of the electronic assembly.

13. The transmission system according to claim 11 wherein the gasket is configured to form a liquid-isolating, redundantly sealed boundary between an electronics cavity and a coolant fluid within one or more coolant cavities of the electronic assembly, the transmission system further comprising:
an adjustable pressure regulator valve and a coolant pressure sensor coupled in series with the coolant lines of the coolant system; where the adjustable pressure regulator is configured to regulate, reduce or limit an observed pressure of the coolant circulating within the one or more coolant cavities of the electronic assembly upon detection of a leak in the gasket or presence of coolant in the overflow vessel, wherein the observed pressure is detected by a coolant pressure sensor.

14. The transmission assembly according to any one of claims 10 to 13 wherein the electronic assembly is:
located within a bottom third of the transmission housing;
submerged within transmission fluid or lubricant in a sump region of the transmission system; or
located at or near a top of the transmission housing.

15. The transmission assembly according to any one of claims 10 to 14 wherein the electronic assembly is located at or near a top of the transmission housing, and wherein first alternating current terminals of the electronic assembly are electrically connected or coupled to first alternating current terminals of the electric machine via conductors that extend laterally and vertically between the first alternating current terminals and the second alternating current terminals, a housing of the electric machine being optionally spaced apart laterally from a housing of the electronic assembly.
